(19) Europäisches Patentamt / European Patent Office / Office européen des brevets

(11) **EP 4 133 589 B1**

(12) **EUROPÄISCHE PATENTSCHRIFT**

(45) Veröffentlichungstag und Bekanntmachung des Hinweises auf die Patenterteilung:
**06.08.2025 Patentblatt 2025/32**

(21) Anmeldenummer: **21715498.8**

(22) Anmeldetag: **22.03.2021**

(51) Internationale Patentklassifikation (IPC):
**G03F 7/00** *(2006.01)* **H02P 25/034** *(2016.01)*
**H02P 7/025** *(2016.01)*

(52) Gemeinsame Patentklassifikation (CPC):
**H02P 25/034; G03F 7/70258; G03F 7/70825; H02P 7/025**

(86) Internationale Anmeldenummer:
**PCT/EP2021/057258**

(87) Internationale Veröffentlichungsnummer:
**WO 2021/204523 (14.10.2021 Gazette 2021/41)**

(54) **VERFAHREN, ANSTEUEREINRICHTUNG, OPTISCHES SYSTEM UND LITHOGRAPHIEANLAGE**

METHOD, ACTUATING DEVICE, OPTICAL SYSTEM AND LITHOGRAPHY SYSTEM

PROCÉDÉ, DISPOSITIF D'ACTIONNEMENT, SYSTÈME OPTIQUE ET SYSTÈME DE LITHOGRAPHIE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **06.04.2020 DE 102020204415**

(43) Veröffentlichungstag der Anmeldung:
**15.02.2023 Patentblatt 2023/07**

(73) Patentinhaber: **Carl Zeiss SMT GmbH**
**73447 Oberkochen (DE)**

(72) Erfinder: **RHEIN, Soenke**
**89564 Nattheim (DE)**

(74) Vertreter: **HKW Intellectual Property PartG mbB**
**Theresienhöhe 12**
**80339 München (DE)**

(56) Entgegenhaltungen:
**DE-A1- 102014 206 686 US-A1- 2010 284 119**
**US-A1- 2019 103 829**

- **KROUGLICOF NICHOLAS ET AL: "Development of a novel PCB-based voice coil actuator for opto-mechatronic applications", 2013 IEEE/RSJ INTERNATIONAL CONFERENCE ON INTELLIGENT ROBOTS AND SYSTEMS(ROS), IEEE, 3 November 2013 (2013-11-03), pages 5834 - 5840, XP032537238, ISSN: 2153-0858, [retrieved on 20131227], DOI: 10.1109/IROS.2013.6697201**

**Beschreibung**

Die vorliegende Erfindung betrifft ein Verfahren zum Betreiben eines magnetischen Aktuators, eine Ansteuereinrichtung für einen magnetischen Aktuator, ein optisches System mit einem entsprechend gesteuerten Aktuator und eine Lithographieanlage mit einem solchen optischen System.

Es sind magnetische Aktuatoren bekannt, die einen Permanentmagneten und eine elektrische Leiteranordnung aufweisen. Wenn ein Strom durch die elektrische Leiteranordnung fließt, wird ein Magnetfeld induziert, welches mit dem Magnetfeld des Permanentmagneten in Wechselwirkung tritt. Diese Wechselwirkung zeigt sich beispielsweise in einer mechanischen Kraft, die zwischen der elektrischen Leiteranordnung und dem Permanentmagneten wirkt. Wenn die Kraft linear mit steigendem Strom ansteigt, kann man den Aktuator beispielsweise durch eine Motorkonstante charakterisieren. Die Motorkonstante entspricht dabei dem Proportionalitätsfaktor zwischen Kraft und Strom. US 2010/284119 A1 offenbart eine Vorrichtung zum Steuern einer Tauchspule eines Aktuators. Der Aktuator wird benutzt, um die Position eines Wafers innerhalb eines optischen Systems zu Steuern. Durch eine Änderung der Temperatur des Aktuators wird die erzeugte Kraft und somit auch die Position verändert. Um die Position konstant zu halten, wird die Temperatur des Aktuators mit einer Infrarotkamera gemessen und ein korrigierter Strom eingeprägt, der den Positionsfehler ausgleicht.

Die Größe der Kraft hängt dabei vor allem von geometrischen Faktoren und der Stärke der jeweiligen Magnetfelder ab. Die Wechselwirkung hat eine Erwärmung des Permanentmagneten zur Folge. Je größer der Strom ist, umso stärker ist die Erwärmung. Aufgrund der Erwärmung sinkt die Magnetisierung und damit die Magnetfeldstärke des Permanentmagneten ab, was zu einer Reduzierung der effektiven Kraft führt. Man kann auch sagen, dass sich die Motorkonstante verringert. Um eine zeitlich konstante Kraft zu erzielen, muss daher der Strom erhöht werden.

Bekannte Steuerungen für magnetische Aktuatoren umfassen beispielsweise Temperatursensoren auf dem Permanentmagneten, um die Temperaturabhängigkeit der Motorkonstante zu berücksichtigen. Diese Lösung ist technisch aufwändig, da beispielsweise ein Bauraum beengt ist, da die Aktuatoren im Vakuum betrieben werden, und da eine aufwändige Berechnung der tatsächlichen Temperatur des Permanentmagneten auf Basis der erfassten Temperatur an dessen Oberfläche durchgeführt werden muss. Zudem greift eine solche Regelung erst ein, wenn sich die Temperatur auch an der Oberfläche des Permanentmagneten erhöht. Weiterhin ist diese Lösung unbefriedigend, da die Temperaturabhängigkeit der Motorkonstante für einen jeweiligen Aktuator genau bekannt sein muss, was häufig nicht der Fall ist, weshalb trotz des hohen Aufwands nur ein geringer Vorteil erzielt wird.

Insbesondere optische Systeme mit hohen Präzisionsanforderungen, wie beispielsweise in der Mikrolithographie, können von einem verbesserten Steuerungsverfahren für magnetische Aktuatoren profitieren.

Vor diesem Hintergrund besteht eine Aufgabe der vorliegenden Erfindung darin, ein verbessertes Verfahren zum Betreiben eines magnetischen Aktuators bereitzustellen.

Gemäß einem ersten Aspekt wird ein Verfahren zum Betreiben eines magnetischen Aktuators, insbesondere zum Aktuieren eines optischen Elements in einem optischen System, welcher zum Bereitstellen einer mechanischen Kraft in Abhängigkeit einer elektrischen Ansteuerleistung eingerichtet ist, vorgeschlagen. In einem ersten Schritt wird ein mathematisches Modell des Aktuators, welches eine Veränderung einer Motorkonstante des Aktuators in Abhängigkeit einer zugeführten elektrischen Ansteuerleistung beschreibt, ermittelt. In einem zweiten Schritt wird der Aktuator mit einer ersten elektrischen Ansteuerleistung in Abhängigkeit einer vorbestimmten Sollkraft angesteuert. In einem dritten Schritt wird die Veränderung der Motorkonstante des Aktuators aufgrund des Ansteuerns des Aktuators mit der ersten elektrischen Ansteuerleistung mittels des mathematischen Modells ermittelt. In einem vierten Schritt wird ein Korrekturwert für die erste elektrische Ansteuerleistung in Abhängigkeit der ermittelten Veränderung der Motorkonstante ermittelt. In einem fünften Schritt wird der Aktuator mit einer zweiten elektrischen Ansteuerleistung in Abhängigkeit der ersten elektrischen Ansteuerleistung und des ermittelten Korrekturwerts angesteuert.

Dieses Verfahren weist den Vorteil auf, dass die Steuerung des Aktuators unter Berücksichtigung der Veränderung der Motorkonstanten aufgrund einer Eigenerwärmung im Betrieb des Aktuators erfolgt, wodurch die Steuerung sehr präzise erfolgen kann. Weiterhin hat das Verfahren den Vorteil, dass eine explizite Temperaturmessung einer Aktuator-Temperatur nicht erforderlich ist. Damit kann der Aufbau der Steuerung erheblich vereinfacht werden, einerseits weil keine Temperatursensoren benötigt werden, und andererseits, weil eine aufwändige Berechnung der Temperatur in dem Aktuator auf Basis einer Temperaturmessung an dessen Oberfläche und die hieraus resultierende Motorkonstante entfällt. Hinzu kommt, dass die Steuerung nicht auf die Messung einer sich langsam ändernden Größe, der Temperatur des Aktuators, angewiesen ist, weshalb die Korrektur im Grunde ohne zeitliche Verzögerung erfolgt. Vorteilhaft kann die Veränderung der Motorkonstanten beispielsweise auch a-priori berücksichtigt werden, da die elektrische Ansteuerleistung für den jeweils nächsten Steuerzeitraum bereits bekannt oder vorbestimmt ist.

Beispielsweise soll während der Belichtung eines Wafers in einer Lithographieanlage eine Linse gemäß einer vorbestimmten Trajektorie bewegt werden, um eine hohe Auflösung zu erreichen. Hierzu wird der Aktuator auf Basis des mathematischen Modells mit einer entsprechenden Ansteuerleistung angesteuert. Die tatsächliche Ansteuerleistung wird beispielsweise messtechnisch erfasst und als Eingangsgröße dem mathematischen Modell bereitgestellt, woraufhin sich beispielsweise die Motorkonstante in dem mathematischen Modell ändert. Dementsprechend muss, um die korrekte Position oder Auslenkung des Aktuators zu erreichen, die Ansteuerleistung korrigiert werden. Man kann daher sagen, dass das mathematische Modell das reale Verhalten des Aktuators auf Basis der tatsächlichen Ansteuerleistung simuliert.

Der magnetische Aktuator umfasst zumindest einen Permanentmagneten und eine Leiteranordnung, die relativ zu dem Permanentmagneten derart angeordnet ist, dass sich eine mechanische Kraftwirkung ergibt, wenn ein elektrischer Strom durch die Leiteranordnung fließt. Beispiele für solche Aktuatoren sind Lorentz-Motoren oder Hallbach-Motoren. Durch den durch den Leiter fließenden Strom wird um den Leiter herum ein Magnetfeld induziert, welches mit dem Magnetfeld des Permanentmagneten in Wechselwirkung tritt, wobei sich eine anziehende oder abstoßende Kraft ergeben kann, je nach relativer Orientierung der Magnetfeldlinien zueinander. Die Größe der Kraft hängt dabei von der Höhe des Stroms ab, mit dem die Leiteranordnung bestromt wird. Dabei ist die Kraft beispielsweise proportional zu einer Stromstärke. Der Proportionalitätsfaktor zwischen Kraft und Strom wird beispielsweise als Motorkonstante bezeichnet. Die Motorkonstante kann beispielsweise als die Ableitung der Kraft nach dem Eingangsstrom berechnet werden. Die Motorkonstante ist dabei insbesondere für einen jeweiligen Aktuator individuell unterschiedlich. Die Motorkonstante weist aufgrund der Temperaturabhängigkeit der Magnetisierung des Permanentmagneten ebenfalls eine Temperaturabhängigkeit auf.

Der Aktuator wird mit einer elektrischen Ansteuerleistung betrieben. Diese ist beispielsweise als das Produkt aus Spannung und Strom gegeben. Bei einer konstanten Spannung, die beispielsweise von einer Spannungsquelle bereitgestellt wird, kann die Ansteuerleistung daher durch den Strom verändert werden. Je höher die Ansteuerleistung, umso höher ist auch die Kraft, die der Aktuator bereitstellt. Allerdings erhöht sich damit auch die in dem Aktuator dissipierte Leistung, wodurch sich der Permanentmagnet des Aktuators erwärmt. Bei einem Permanentmagnet ist die Größe der magnetischen Flussdichte von der Temperatur abhängig, weshalb auch die bereitgestellte Kraft über das Magnetfeld von der Temperatur abhängt. Man kann auch sagen, dass die Motorkonstante von der Temperatur abhängt.

Um diese Abhängigkeit zu kompensieren, wird vorgeschlagen, ein mathematisches Modell des Aktuators zu ermitteln, welches den Zusammenhang zwischen der Motokonstanten und der Temperatur beschreibt. Man kann sagen, das mathematische Modell beschreibt das Aufheizverhalten des Permanentmagneten als Funktion der elektrischen Ansteuerleistung. Das Ermitteln des mathematischen Modells kann ein Auswählen eines Grundmodells, beispielsweise basierend auf physikalischen Überlegungen, und ein Festlegen von Parameterwerten des Grundmodells, beispielsweise basierend auf geometrischen Eigenschaften des Aktuators, umfassen. Unter einem Grundmodell kann zum Beispiel ein theoretisches Modell oder auch ein empirisches Modell des Aufheizverhaltens des Permanentmagneten als Funktion der elektrischen Ansteuerleistung verstanden werden.

Insbesondere wird das mathematische Modell in einem ersten Schritt mittels einer Messung des Zusammenhangs zwischen elektrischer Ansteuerleistung und der erzielten Kraftwirkung ermittelt. Beispielsweise wird der Aktuator für eine längere Zeit mit einer konstanten hohen Ansteuerleistung betrieben. Der Aktuator beginnt, sich zu erwärmen, bis sich ein Gleichgewicht zwischen der zugeführten Energie und der von dem Aktuator abgegebenen Wärmenergie einstellt (thermisches Gleichgewicht). Die Veränderung der Motorkonstanten erfolgt daher nicht sprunghaft, sondern stetig mit einer Zeitkonstanten, die beispielsweise von der zugeführten Leistung und der Wärmekapazität des Permanentmagneten abhängt. Im thermischen Gleichgewicht ist die Motorkonstante konstant. Diese Messung kann auch als Kalibriermessung bezeichnet werden und sie wird vorzugsweise unter Verwendung eines geschlossenen Regelkreises für den Aktuator unter Beobachtung aller relevanten Messgrößen durchgeführt. Die Kalibriermessung kann beispielsweise mit einem spezifischen Test-Stand durchgeführt werden. Alternativ oder zusätzlich kann die Kalibriermessung für den Aktuator im eingebauten Zustand des Aktuators durchgeführt werden, wobei unter "eingebautem Zustand" insbesondere verstanden wird, dass der Aktuator in dem System, beispielsweise dem optischen System, und in der Funktion, in dem er später einmal zum Einsatz kommen soll, eingebaut ist. Dies hat den Vorteil, dass die Umgebungsbedingungen bereits denen des späteren Betriebs des Aktuators entsprechen, weshalb alle möglichen Effekte, die das Aufheizverhalten des Aktuators beeinflussen, implizit in dem mathematischen Modell enthalten sind, ohne dass diese explizit bekannt sein müssen. Ist das mathematische Modell des Aktuators auf diese Weise ermittelt, kann der Aktuator im Regelbetrieb des Aktuators unter Berücksichtigung einer entsprechend korrigierten Motorkonstante angesteuert werden, wie nachfolgend beschrieben.

In dem zweiten Schritt wird der Aktuator mit einer ersten elektrischen Ansteuerleistung in Abhängigkeit einer vorbestimmten Sollkraft angesteuert. Die vorbestimmte Sollkraft wird beispielsweise durch eine Steuer- oder Regeleinrichtung von außen vorgegeben. Durch die vorbestimmte Sollkraft wird dabei insbesondere eine lineare Auslenkung des Aktuators erzielt, wodurch beispielsweise ein gekoppeltes optisches Element deformiert oder verschoben wird. Die vorbestimmte Sollkraft kann bei bekannter mechanischer Kopplung auch durch eine vorbestimmte Sollposition des Aktuators gegeben sein.

In dem dritten Schritt wird die Veränderung der Motorkonstanten des Aktuators aufgrund des Ansteuerns des Aktuators mit der ersten elektrischen Ansteuerleistung mittels des mathematischen Modells ermittelt. Man kann sagen, dass hierzu das mathematische Modell ausgewertet oder simuliert wird. Indem das mathematische Modell während des Betriebs des Aktuators simultan mit der dem Aktuator zugeführten Ansteuerleistung simuliert wird, werden von diesem alle in der Vergangenheit liegenden Werte für die Ansteuerleistung berücksichtigt. Man kann auch sagen, dass der in der Vergangenheit liegende zeitliche Verlauf der ersten elektrischen Ansteuerleistung in die Berechnung eingeht. Dies ist vorteilhaft, da die Erwärmung des Aktuators zeitlich verzögert erfolgt. Formal kann das mathematische Modell beispielsweise eine Darstellung in Form einer Differentialgleichung umfassen.

In dem vierten Schritt wird ein Korrekturwert für die erste elektrische Ansteuerleistung in Abhängigkeit der ermittelten Veränderung der Motorkonstanten ermittelt. Der Korrekturwert ist beispielsweise der Wert, der zu der ersten elektrischen Ansteuerleistung hinzuaddiert werden muss, um die vorbestimmte Sollkraft bereitzustellen.

In dem fünften Schritt wird der Aktuator mit einer zweiten elektrischen Ansteuerleistung in Abhängigkeit der ersten elektrischen Ansteuerleistung und des ermittelten Korrekturwerts angesteuert. Die zweite elektrische Ansteuerleistung entspricht beispielsweise der Summe aus dem Korrekturwert und der ersten elektrischen Ansteuerleistung.

Das Verfahren ermöglicht es, bereits vor dem Auftreten von Aktuierungsfehlern, die nachträglich von einer Regelung ausgeregelt werden müssten, bereits in der Vorsteuerung den Effekt der Veränderung der Motorkonstanten aufgrund der Erwärmung zu berücksichtigen, was zu einer verbesserten Aktuierungsgenauigkeit durch den magnetischen Aktuator führt.

Gemäß einer Ausführungsform des Verfahrens ist die jeweilige elektrische Ansteuerleistung proportional zu einem Eingangsstrom an dem Aktuator.

Der Aktuator wird vorzugsweise mit einer Spannungsquelle betrieben, die eine konstante elektrische Spannung an den Klemmen bereitstellt. Die Spannung ist dann beispielsweise der Proportionalitätsfaktor zwischen dem Eingangsstrom und der elektrischen Ansteuerleistung.

Gemäß einer weiteren Ausführungsform des Verfahrens umfasst der Schritt des Ermittelns des mathematischen Modells mehrere Teilschritte. Insbesondere wird das mathematische Modell ermittelt, indem der Aktuator in einem geschlossenen Regelkreis betrieben wird. In einem ersten Teilschritt wird der Aktuator mit der ersten elektrischen Ansteuerleistung zum Bereitstellen der vorbestimmten Sollkraft angesteuert. In einem zweiten Teilschritt wird die durch den Aktuator bereitgestellte Kraft erfasst. In einem dritten Teilschritt wird die erste elektrische Ansteuerleistung in Abhängigkeit der erfassten Kraft geregelt. Dies erfolgt derart, dass die bereitgestellte Kraft der vorbestimmten Sollkraft entspricht und zeitlich konstant ist, was sich über die erfasste Kraft kontrollieren und damit regeln lässt. Vorteilhaft erfolgt die Kraftänderung, wenn sich die Motorkonstante ändert, instantan, so dass ein zeitlicher Fehler nicht auftritt. In einem vierten Teilschritt wird eine zeitliche Veränderung der ersten elektrischen Ansteuerleistung erfasst. Die erste elektrische Ansteuerleistung ist insbesondere aufgrund der Regelung zeitlich nicht unbedingt konstant. In einem fünften Teilschritt wird ein den zeitlichen Verlauf der elektrischen Ansteuerleistung beschreibendes Modell ermittelt und/oder zumindest ein Parameterwert des mathematischen Modells in Abhängigkeit der erfassten zeitlichen Veränderung der ersten elektrischen Ansteuerleistung ermittelt.

In Ausführungsformen kann anstelle einer Kraftregelung eine Positionsregelung verwendet werden. Das heißt, dass nicht die Kraft des Aktuators erfasst und konstant gehalten wird, sondern die Position des Aktuators oder eines durch diesen aktuierten Elements. In weiteren Ausführungsformen kann eine Stromregelung erfolgen, wobei der Strom konstant gehalten wird und die von dem Aktuator bereitgestellte Kraft erfasst wird.

Das Ermitteln des Modells umfasst beispielsweise ein Vergleichen der erfassten zeitlichen Veränderung der elektrischen Ansteuerleistung mit theoretisch vorhergesagten Verlaufskurven. Das Modell, das die Verlaufskurve mit der geringsten Abweichung zu den Messdaten erzeugt hat, kann als das beste Modell betrachtet werden. Vorzugsweise werden Parameterwerte eines solchen Modells an die Messdaten angepasst. Beispielsweise ist ein funktionaler Verlauf des Zusammenhangs von elektrischer Ansteuerleistung und bereitgestellter Kraft für eine bestimmte Aktuator-Klasse bereits bekannt, aber genaue Werte für Parameter des Modells können für einen bestimmten Aktuator-Typ noch unbekannt sein. Solche Parameterwerte lassen sich durch ein Anpassen, auch "fitten" genannt, des Modells an die Messdaten ermitteln, wobei beispielsweise eine Fehlerfunktion minimiert wird, um den besten Parameterwert oder, bei mehreren anzupassenden Parametern, den besten Satz an Parameterwerten zu ermitteln.

Vorteilhaft umfasst das derart ermittelte mathematische Modell alle möglichen Effekte, die das Aufheizverhalten des Aktuators und die Änderung der Motorkonstanten beeinflussen, ohne dass diese explizit bekannt oder durch eine Gleichung beschrieben werden müssen.

Gemäß einer weiteren Ausführungsform des Verfahrens ist ein Erfassen der dem Aktuator zugeführten elektrischen Ansteuerleistung vorgesehen, wobei diese bei dem dritten Schritt zum Ermitteln der Veränderung der Motorkonstante verwendet wird.

Diese Ausführungsform ist vorteilhaft, da beispielsweise kleine Schwankungen der tatsächlich zugeführten elektrischen Ansteuerleistung bei der Steuerung berücksichtigt werden können. Insbesondere wenn die geforderte elektrische Ansteuerleistung sich stark verändert, beispielsweise zum Anfahren einer anderen Position, benötigt die Spannungsquelle eine bestimmte endliche Zeit, um den erforderlichen Strom bereitzustellen, was somit berücksichtigt werden kann. Eine Genauigkeit der Kompensation der Veränderung der Motorkonstanten ist damit weiter erhöht. Zudem lassen sich Blindanteile in der elektrischen Ansteuerleistung, die zu einer Erwärmung nicht beitragen, erfassen und entsprechend berücksichtigen.

Gemäß einer weiteren Ausführungsform des Verfahrens ist ein Erfassen einer aktuellen Aktuator-Temperatur vorgesehen, wobei die erfasste Aktuator-Temperatur im dritten Schritt zum Ermitteln der Veränderung der Motorkonstante als Rückkopplung von dem magnetischen Aktuator verwendet wird.

Diese Ausführungsform ist vorteilhaft, da hierdurch eine Rückkopplung des tatsächlichen Aktuators auf das mathematische Modell erfolgt. Dies verhindert vorzugsweise, dass die dynamische Entwicklung des mathematischen Modells von den tatsächlichen Gegebenheiten abdriftet, was aufgrund kleiner Diskrepanzen zwischen der dem mathematischen Modell als Eingangsgröße bereitgestellten elektrischen Ansteuerleistung und der tatsächlichen Ansteuerleistung vorkommen könnte. Ein ungewolltes Abdriften des mathematischen Modells gegenüber dem tatsächlichen Aktuator-Zustand aufgrund von Ungenauigkeiten des mathematischen Modells kann durch die Rückkopplung ebenfalls vermieden werden. Die erfasste Aktuator-Temperatur entspricht beispielsweise einer Spulentemperatur, die vorzugsweise aus dem Spulenstrom und der Spulenspannung abgeleitet wird. Ein Temperatursensor ist hierbei nicht zwingend notwendig. Die Aktuator-Temperatur wird beispielsweise periodisch erfasst und dem mathematischen Modell zugeführt. Hierdurch wird die dynamische Entwicklung des mathematischen Modells immer wieder korrigiert, sofern sich dieses von der Realität wegentwickelt. Beispielsweise umfasst das mathematische Modell hierbei ein Kalman-Filter, das in Abhängigkeit von der (dem mathematischen Modell zugeführten) elektrischen Ansteuerleistung die Aktuator-Temperatur schätzt. Durch Abgleich mit der erfassten Aktuator-Temperatur lassen sich Fehler in der dem mathematischen Modell zugeführten elektrischen Ansteuerleistung oder Ungenauigkeiten des mathematischen Modells korrigieren und damit ein Abdriften der Modellierung vermeiden.

Gemäß einer weiteren Ausführungsform des Verfahrens wird der erste Schritt, bei dem das mathematische Modell ermittelt wird, bei Umgebungsbedingungen durchgeführt, die den vorgesehenen Betriebsbedingungen des Aktuators entsprechen.

Diese Ausführungsform stellt sicher, dass die Bedingungen beim Ermitteln des mathematischen Modells jenen entsprechen, die im Betrieb des Aktuators, beispielsweise in einer Lithographieanlage, ebenfalls vorherrschen. Insbesondere eine Umgebungstemperatur sowie Bedingungen, die eine Dissipation von Wärme von dem Aktuator beeinflussen (Luftdruck, molekulare Zusammensetzung des umgebenden Gases, Luftströmungen, Kühlung usw.) werden hierbei berücksichtigt.

Gemäß einer weiteren Ausführungsform des Verfahrens wird das mathematische Modell durch zumindest ein PT1-Glied und ein PT0-Glied abgebildet.

Diese Ausführungsform erlaubt eine Darstellung des zeitlichen Verhaltens der Motorkonstanten des Aktuators mittels einer geeigneten Regelstrecke, beispielsweise in Form eines Blockschaltbilds. Ein PT0-Glied kann auch als Proportionalglied bezeichnet werden und ein PT1-Glied kann auch als Verzögerungsglied 1. Ordnung bezeichnet werden.

Das PT0-Glied gibt dabei ein an einem Eingang anliegendes Signal ohne zeitliche Verzögerung proportional an einem Ausgang aus. Vorliegend entspricht der Eingang beispielsweise dem dem Aktuator zugeführten Strom, der Ausgang entspricht der bereitgestellten Kraft und die Proportionalitätskonstante (Verstärkungsfaktor) ist die (temperaturabhängige) Motorkonstante des Aktuators.

Das PT1-Glied weist eine zeitliche Verzögerung auf, weshalb ein Ausgangssignal des PT1-Glieds zwar proportional zu dem Eingangssignal ist, diesem aber mit einer Verzögerung folgt, wobei ein funktionaler Zusammenhang zwischen Eingangssignal und Ausgangssignal beispielsweise durch nachfolgende Gleichung (1) beschrieben werden kann. In Gleichung (1) beschreibt Y(t) das Ausgangssignal zum Zeitpunkt t, X steht für das Eingangssignal, t steht für die Zeit und T ist die Zeitkonstante, deren Wert beispielsweise von physikalischen Parametern abhängt und experimentell für ein gegebenes System gemessen werden kann.

$$Y(t) = X \cdot (1 - e^{-t/T}) \qquad \text{Gleichung (1)}.$$

Alternativ kann Gleichung (1) auch als Differentialgleichung geschrieben werden, wie nachfolgend in Gleichung (2) dargestellt. Die Größen sind hierbei wie in Gleichung (1) definiert und d/dt ist der Differentialoperator nach der Zeit t.

$$d(T \cdot Y(t))/dt + Y(t) = X(t) \qquad \text{Gleichung (2)}.$$

Das PT1-Glied ist insbesondere zur Beschreibung von Wärmeleitvorgängen in Festkörpern geeignet. Wie vorstehend bereits beschrieben, nähert sich der Aktuator bei konstanten Umgebungsbedingungen und konstanter zugeführter elektrischer Leistung einem thermischen Gleichgewicht an, was durch das PT1-Glied beschrieben werden kann. Vorzugsweise stellt das PT1-Glied die Erwärmung des Aktuators als Funktion der elektrischen Ansteuerleistung dar, wobei ein Proportionalitätsfaktor (Verstärkungsfaktor) zwischen Eingang und Ausgang von einer Temperaturabhängigkeit der Motorkonstanten abhängt. Der Ausgang des PT1-Glieds ist damit repräsentativ für den zusätzlichen Strom, der notwendig ist, um die vorbestimmte Sollkraft bei einer sich langsam ändernden Motorkonstanten zu erhalten. Das PT1-Glied ist insbesondere durch den Proportionalitätsfaktor und die Zeitkonstante charakterisiert.

In weiteren Ausführungsformen kann das mathematische Modell weitere P-Glieder, beispielsweise mehrere in Reihe geschaltete PT1-Glieder, ein PT2-Glied und/oder Glieder noch höherer Ordnung umfassen. Beispielsweise kann das PT1-Glied durch ein PTn-Glied ersetzt werden, wobei n die Ordnung des P-Glieds angibt.

Gemäß einer weiteren Ausführungsform des Verfahrens wird das mathematische Modell auf Basis einer theoretischen Beschreibung des Aktuators ausgewählt, wobei bei dem ersten Schritt zumindest ein Parameterwert des Modells bestimmt wird.

Unter der theoretischen Beschreibung des Aktuators wird vorliegend insbesondere eine Beschreibung des Zusammenhangs zwischen der zugeführten elektrischen Ansteuerleistung und der erzielten Kraft verstanden, sowie eine Beschreibung des Aufheizverhaltens in Abhängigkeit der elektrischen Ansteuerleistung. Beispielsweise wird ein PT1-Glied ausgewählt, um das dynamische Verhalten des Aktuators zu beschreiben, wobei bei dem ersten Schritt der Proportionalitätsfaktor und die Zeitkonstante bestimmt werden.

Das Bestimmen des zumindest einen Parameterwerts kann man auch als Kalibrieren des Modells oder Parametrisieren des Modells bezeichnen.

Gemäß einem zweiten Aspekt wird ein Verfahren zum Betreiben eines optischen Systems vorgeschlagen. Das optische System weist eine Anzahl von optischen Elementen auf, wobei wenigstens eines der optischen Elemente der Anzahl mittels eines gekoppelten magnetischen Aktuators aktuierbar ist. Der Aktuator wird zum Aktuieren des optischen Elements mittels des Verfahrens gemäß dem ersten Aspekt betrieben.

Dieses Verfahren weist den Vorteil auf, dass die Aktuierung des optischen Elements, die beispielsweise eine Verschiebung, eine Drehung und/oder eine mechanische Verspannung oder Deformation des optischen Elements sein kann, besonders präzise erfolgt. Durch die Aktuierung des optischen Elements lassen sich beispielsweise optische Aberrationen des optischen Systems kompensieren und/oder eine variable Strahlführung realisieren.

Das optische System ist beispielsweise ein Strahlenführungssystem eines optischen Instruments, wie eines Mikroskops, eines Teleskops, eines optischen Messsystems oder einer Lithographieanlage. Es sei darauf hingewiesen, dass das optische System nicht auf den sichtbaren Wellenlängenbereich des elektromagnetischen Spektrums begrenzt ist, sondern darüber hinausgehen kann. So sind auch optische Systeme für Gammastrahlung, Röntgenstrahlung oder UV-Strahlung, insbesondere EUV-Strahlung, aber auch für IR-Strahlung, Mikrowellenstrahlung oder Terahertzstrahlung hierunter zu verstehen.

Das optische System umfasst in Abhängigkeit des Wellenlängenbereichs unterschiedliche optische Elemente. Ein optisches Element ist hierbei jedes Element, das gezielt zur Beeinflussung eines Strahlengangs von Strahlung in dem optischen System angeordnet ist. Beispiele für das optische Element sind insbesondere Linsen, Spiegel, Gitter und Blenden.

Durch die Aktuierung des zumindest einen optischen Elements wird der Strahlengang des optischen Systems gezielt beeinflusst. So kann beispielsweise eine Brennebene einer Linse oder eines Spiegels verschoben werden oder eine Blende eingestellt werden. Durch die Aktuierung lassen sich somit unterschiedliche optische Konfigurationen des optischen Systems erzielen. Weiterhin können durch die Aktuierung auch Aberrationen, wie beispielsweise eine Verzeichnung oder eine Wellenfrontaberration, ausgeglichen werden. Damit kann eine Genauigkeit oder Abbildungsgüte des optischen Systems erhöht werden.

Vorliegend ist die Aktuierung des optischen Elements mit dem Aktuator gemäß dem Verfahren des ersten Aspekts vorteilhaft, da mittels des mathematischen Modells die Veränderung der Motorkonstanten des Aktuators während des laufenden Betrieb kontinuierlich ermittelt und die elektrische Ansteuerleistung entsprechend korrigiert werden kann. Dabei erfolgt die Korrektur insbesondere im Rahmen der Vorsteuerung, also ohne, dass die tatsächliche erzielte Auslenkung erfasst werden müsste. Es ergibt sich auf diese Weise eine verbesserte Genauigkeit bei reduziertem Aufwand.

Die für das Verfahren gemäß dem ersten Aspekt beschriebenen Ausführungsformen und Merkmale gelten auch für das vorgeschlagene Verfahren gemäß dem zweiten Aspekt.

Gemäß einem dritten Aspekt wird ein Computerprogrammprodukt vorgeschlagen, welches Befehle umfasst, die bei der Ausführung des Programms durch einen Computer diesen veranlassen, das Verfahren gemäß dem ersten oder zweiten Aspekt durchzuführen.

Ein Computerprogrammprodukt, wie z.B. ein Computerprogramm-Mittel, kann beispielsweise als Speichermedium, wie z.B. Speicherkarte, USB-Stick, CD-ROM, DVD, oder auch in Form einer herunterladbaren Datei von einem Server in einem Netzwerk bereitgestellt oder geliefert werden. Dies kann zum Beispiel in einem drahtlosen Kommunikationsnetzwerk durch die Übertragung einer entsprechenden Datei mit dem Computerprogrammprodukt oder dem Computerprogramm-Mittel erfolgen.

Gemäß einem vierten Aspekt wird eine Ansteuereinrichtung zum Ansteuern eines magnetischen Aktuators zum Bereitstellen einer mechanischen Kraft in Abhängigkeit einer elektrischen Ansteuerleistung vorgeschlagen. Die Ansteuereinrichtung umfasst eine Modelliereinheit zum Bereitstellen eines mathematischen Modells des Aktuators, welches eine Veränderung einer Motorkonstanten des Aktuators in Abhängigkeit der elektrischen Ansteuerleistung beschreibt, eine Ansteuerungseinheit zum Ansteuern des Aktuators mit einer ersten elektrischen Ansteuerleistung in Abhängigkeit einer vorbestimmten Sollkraft, eine Auswerteeinheit zum Ermitteln einer Veränderung der Motokonstanten des Aktuators aufgrund des Ansteuerns des Aktuators mit der ersten elektrischen Ansteuerleistung und in Abhängigkeit des von der Modelliereinheit bereitgestellten mathematischen Modells, und eine Korrektureinheit zum Ermitteln eines Korrekturwerts für die erste elektrische Ansteuerleistung in Abhängigkeit der ermittelten Veränderung der Motorkonstanten des Aktuators. Die Ansteuerungseinheit ist dazu eingerichtet, den Aktuator mit einer zweiten elektrischen Ansteuerleistung in Abhängigkeit der ersten elektrischen Ansteuerleistung und des ermittelten Korrekturwerts anzusteuern.

Die Ansteuereinrichtung wird vorzugsweise gemäß dem Verfahren gemäß dem ersten Aspekt betrieben. Die Ausführungsformen und Merkmale des Verfahrens des ersten Aspekts gelten für die Ansteuereinrichtung entsprechend.

Die Ansteuereinrichtung ist beispielsweise ein Teil einer Vorsteuerung zum Steuern des magnetischen Aktuators. Die Ansteuereinrichtung und/oder die jeweilige Einheit, wie die Modelliereinheit, Ansteuerungseinheit, Auswerteeinheit und Korrektureinheit, kann hardwaretechnisch und/oder softwaretechnisch implementiert sein. Bei einer hardwaretechnischen Implementierung kann die Ansteuereinrichtung und/oder die jeweilige Einheit zum Beispiel als Computer oder als Mikroprozessor ausgebildet sein. Bei einer softwaretechnischen Implementierung kann die Ansteuereinrichtung und/oder die jeweilige Einheit als Computerprogrammprodukt, als eine Funktion, als eine Routine, als Teil eines Programmcodes oder als ausführbares Objekt ausgebildet sein.

Die Ansteuereinrichtung umfasst vorzugsweise eine Spannungs- oder Stromquelle, um den Aktuator anzusteuern.

Gemäß einer Ausführungsform der Ansteuereinrichtung ist eine Erfassungseinheit zum Erfassen einer dem Aktuator zugeführten elektrischen Ansteuerleistung vorgesehen, wobei die Auswerteeinheit zum Ermitteln der Veränderung der Motokonstante in Abhängigkeit der erfassten elektrischen Ansteuerleistung eingerichtet ist.

Die Erfassungseinheit umfasst beispielsweise eine Spannungsmesseinheit, die die an dem Aktuator anliegende Spannung erfasst, und eine Strommesseinheit, die den dem Aktuator zugeführten Strom erfasst. Hierdurch ist die tatsächliche elektrische Ansteuerleistung zu jedem Zeitpunkt genau bekannt, was entsprechend bei der Ermittlung des Korrekturwerts berücksichtigt werden kann. Hierdurch kann der Aktuator noch genauer, beispielsweise mit einer noch höheren Positioniergenauigkeit, betrieben werden.

Um eine höhere Genauigkeit zu erreichen, kann die Erfassungseinheit in Ausführungsformen ferner eine Phasenlage von Strom und Spannung erfassen, um die tatsächlich zugeführte elektrische Ansteuerleistung noch präziser zu bestimmen. Dies ist insbesondere bei hohen Schaltfrequenzen, also wenn die Lage des Aktuators häufig pro Zeiteinheit verändert oder angepasst wird, vorteilhaft, da gerade beim Umschalten Phasenunterschiede zwischen diesen beiden Größen auftreten können.

In weiteren Ausführungsformen der Ansteuervorrichtung ist eine weitere Erfassungseinheit zum Erfassen einer aktuellen Aktuator-Temperatur vorgesehen. Die erfasste Aktuator-Temperatur kann hierbei dem mathematischen Modell als physikalische Rückkopplung zugeführt werden, um Messfehler zu korrigieren. Die aktuelle Aktuator-Temperatur entspricht beispielsweise einer Spulentemperatur einer Spule des Aktuators.

Gemäß einem fünften Aspekt wird ein mechanisches System mit zumindest einem magnetischen Aktuator zum Aktuieren eines Stellelements vorgeschlagen. Der Aktuator ist zum Bereitstellen einer mechanischen Kraft in Abhängigkeit einer elektrischen Ansteuerleistung eingerichtet. Das mechanische System umfasst wenigstens eine Ansteuereinrichtung zum Ansteuern des magnetischen Aktuators gemäß dem vierten Aspekt.

Das mechanische System ist beispielsweise als ein Manipulator in einem Robotersystem ausgebildet. Das mechanische System ist vorzugsweise in einem Automatisierungssystem zur Herstellung oder Bearbeitung von Objekten angeordnet. Insbesondere bei der Herstellung oder Bearbeitung von Hochpräzisionsteilen, wie beispielsweise in der Mikrosystemtechnik oder der Medizintechnik weist das mechanische System den Vorteil auf, dass eine Aktuierungsgenauigkeit durch den Aktuator sehr präzise erfolgt.

Gemäß einem sechsten Aspekt wird ein optisches System mit einer Anzahl an optischen Elementen vorgeschlagen, wobei wenigstens eines der optischen Elemente der Anzahl mittels eines gekoppelten magnetischen Aktuators aktuierbar ist. Der Aktuator ist zum Bereitstellen einer mechanischen Kraft in Abhängigkeit einer elektrischen Ansteuerleistung eingerichtet. Das optische System weist wenigstens eine Ansteuereinrichtung zum Ansteuern des magnetischen Aktuators zum Aktuieren des optischen Elements gemäß dem vierten Aspekt auf.

Dieses optische System weist den Vorteil auf, dass die Aktuierung des optischen Elements, die beispielsweise eine Verschiebung, eine Drehung und/oder eine mechanische Deformation des optischen Elements bewirken kann, besonders präzise erfolgt. Daher ist eine durch die Aktuierung des optischen Elements vorgesehene Korrektur einer optischen Aberration verbessert. Das optische System wird vorzugsweise gemäß dem Verfahren gemäß dem zweiten Aspekt betrieben.

Das optische System bildet beispielsweise einen Strahlengang eines optischen Instruments, wie eines Mikroskops, eines Teleskops oder einer Lithographieanlage. Es sei darauf hingewiesen, dass das optische System nicht auf den sichtbaren Wellenlängenbereich des elektromagnetischen Spektrums begrenzt ist, sondern darüber hinausgehen kann. So sind auch optische Systeme für Gammastrahlung, Röntgenstrahlung oder UV-Strahlung, aber auch für IR-Strahlung, Mikrowellenstrahlung oder Terahertzstrahlung hierunter zu verstehen.

Das optische System umfasst in Abhängigkeit des Wellenlängenbereichs unterschiedliche optische Elemente.

Ein optisches Element ist hierbei jedes Element, das gezielt zur Beeinflussung eines Strahlengangs von Strahlung in dem optischen System angeordnet ist. Beispiele für das optische Element sind insbesondere Linsen, Spiegel, Gitter und Blenden.

Durch die Aktuierung des zumindest einen optischen Elements wird der Strahlengang des optischen System gezielt beeinflusst. So kann beispielsweise eine Brennebene einer Linse oder eines Spiegels verschoben werden oder eine Blende eingestellt werden. Durch die Aktuierung lassen sich somit unterschiedliche optische Konfigurationen des optischen Systems erzielen. Weiterhin können durch die Aktuierung auch Aberrationen, wie beispielsweise eine Verzeichnung oder eine Wellenfrontaberration ausgleichen. Damit kann eine Abbildungsgüte des optischen Systems erhöht werden.

Vorliegend ist die Aktuierung des optischen Elements mit dem Aktuator gemäß dem Verfahren des ersten Aspekts insbesondere dann vorteilhaft, wenn das optische Element entlang einer vorbestimmte Trajektorie aktuiert werden soll, also beispielsweise innerhalb von 10 Sekunden vollständig in eine Richtung ausgelenkt werden soll. Dann ist aufgrund des bekannten Zusammenhangs von elektrischer Ansteuerleistung und bereitgestellter Kraft oder Auslenkung auch schon vorab die elektrische Ansteuerleistung bekannt, mit der der Aktuator angesteuert werden wird. Entsprechend kann mittels des mathematischen Modells die Veränderung der Motorkonstanten des Aktuators ermittelt und die elektrische Ansteuerleistung entsprechend korrigiert werden. Dabei erfolgt die Korrektur insbesondere im Rahmen der Vorsteuerung, also ohne, dass die tatsächlich erzielte Auslenkung erfasst werden müsste.

Gemäß einem siebten Aspekt wird eine Lithographieanlage mit einem optischen System gemäß dem sechsten Aspekt vorgeschlagen.

Bei der Lithographieanlage handelt es sich beispielsweise um eine DUV oder auch EUV Lithographieanlage. Die Vorteile des optischen Systems gelten für die Lithographieanlage entsprechend.

"Ein" ist vorliegend nicht zwingend als beschränkend auf genau ein Element zu verstehen. Vielmehr können auch mehrere Elemente, wie beispielsweise zwei, drei oder mehr, vorgesehen sein. Auch jedes andere hier verwendete Zählwort ist nicht dahingehend zu verstehen, dass eine Beschränkung auf genau die genannte Anzahl von Elementen gegeben ist. Vielmehr sind zahlenmäßige Abweichungen nach oben und nach unten möglich, soweit nichts Gegenteiliges angegeben ist.

Weitere mögliche Implementierungen der Erfindung umfassen auch nicht explizit genannte Kombinationen von zuvor oder im Folgenden bezüglich der Ausführungsbeispiele beschriebenen Merkmalen oder Ausführungsformen. Dabei wird der Fachmann auch Einzelaspekte als Verbesserungen oder Ergänzungen zu der jeweiligen Grundform der Erfindung hinzufügen.

Weitere vorteilhafte Ausgestaltungen und Aspekte der Erfindung sind Gegenstand der Unteransprüche sowie der im Folgenden beschriebenen Ausführungsbeispiele der Erfindung. Im Weiteren wird die Erfindung anhand von bevorzugten Ausführungsformen unter Bezugnahme auf die beigelegten Figuren näher erläutert.

Fig. 1 zeigt ein schematisches Blockschaltbild eines Ausführungsbeispiels eines Verfahrens zum Betreiben eines magnetischen Aktuators;

Fig. 2 zeigt schematisch ein Ausführungsbeispiel eines magnetischen Aktuators;

Fig. 3 zeigt ein beispielhaftes Diagramm einer Motorkonstante bei unterschiedlichen Temperaturen;

Fig. 4 zeigt ein beispielhaftes Diagramm einer Veränderung einer Ansteuerleistung zum Bereitstellen einer konstanten Kraft;

Fig. 5 zeigt ein schematisches Blockschaltbild eines mathematischen Modells eines magnetischen Aktuators;

Fig. 6 zeigt ein schematisches Blockschaltbild eines mathematischen Modells eines magnetischen Aktuators;

Fig. 7 zeigt ein schematisches Blockschaltbild einer Anordnung zum Ermitteln eines mathematischen Modells;

Fig. 8 zeigt ein schematisches Blockschaltbild einer Ansteuereinrichtung zum Ansteuern eines magnetischen Aktuators;

Fig. 9 zeigt schematisch ein Ausführungsbeispiel eines optischen Systems;

Fig. 10A zeigt eine schematische Ansicht einer Ausführungsform einer EUV-Lithographieanlage; und

Fig. 10B zeigt eine schematische Ansicht einer Ausführungsform einer DUV-Lithographieanlage.

In den Figuren sind gleiche oder funktionsgleiche Elemente mit denselben Bezugszeichen versehen worden, soweit nichts Gegenteiliges angegeben ist. Ferner sollte beachtet werden, dass die Darstellungen in den Figuren nicht notwendigerweise maßstabsgerecht sind.

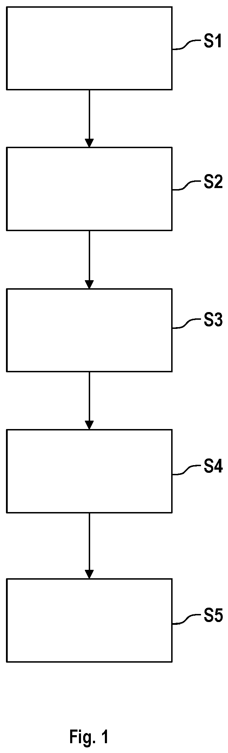

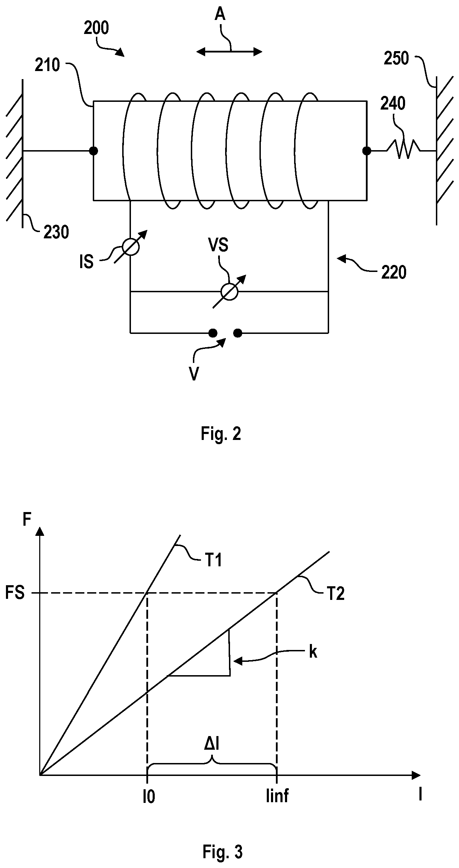

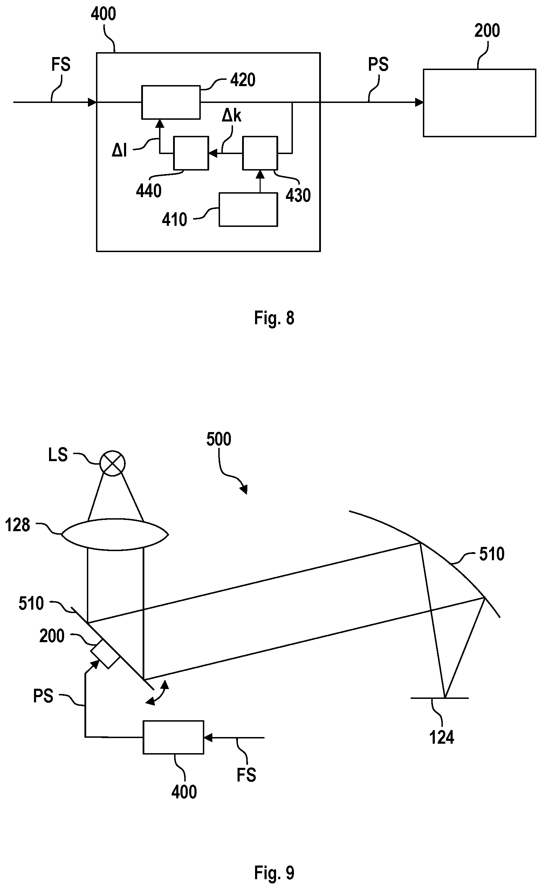

Fig. 1 zeigt ein schematisches Blockschaltbild eines Ausführungsbeispiels eines Verfahrens zum Betreiben eines magnetischen Aktuators 200 (siehe Fig. 2, 7 - 9, 10A und 10B). Der Aktuator 200 ist zum Bereitstellen einer mechanischen Kraft A (siehe Fig. 2) in Abhängigkeit einer elektrischen Ansteuerleistung PS (siehe Fig. 8 oder 9) eingerichtet.

In einem ersten Schritt S1 wird ein mathematisches Modell des Aktuators 200 ermittelt, welches eine Veränderung einer Motorkonstante k (siehe Fig. 3) des Aktuators 200 in Abhängigkeit der zugeführten elektrischen Ansteuerleistung PS beschreibt. Der Zusammenhang zwischen der elektrischen Ansteuerleistung PS und der Motorkonstanten k ist nachfolgend anhand der Fig. 3 - 6 näher erläutert.

In einem zweiten Schritt S2 wird der Aktuator 200 mit einer ersten elektrischen Ansteuerleistung PS in Abhängigkeit einer vorbestimmten Sollkraft FS (siehe Fig. 3, 8, 9, 10A und 10B) angesteuert. Die erste elektrische Ansteuerleistung PS wird auf Basis der (bekannten) Motorkonstanten k bei bestimmten Bedingungen, beispielsweise Normalbedingungen, bestimmt.

In einem dritten Schritt S3 wird die Veränderung der Motorkonstanten k des Aktuators 200 aufgrund des Ansteuerns des Aktuators 200 mit der ersten elektrischen Ansteuerleistung PS mittels des mathematischen Modells ermittelt. Beispielsweise wird das mathematische Modell ausgewertet, wobei als Eingangsgröße insbesondere die elektrische Ansteuerleistung PS dient.

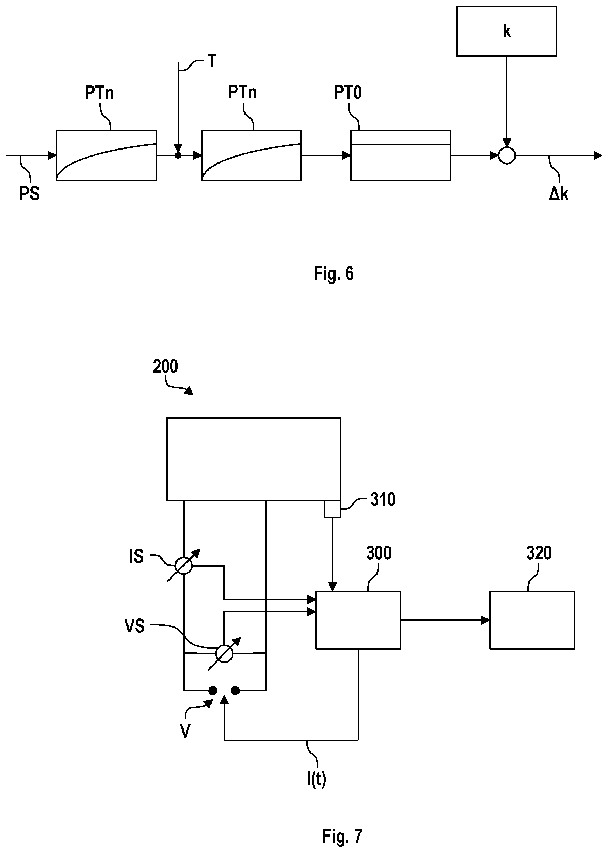

In einem vierten Schritt S4 wird ein Korrekturwert für die erste elektrische Ansteuerleistung PS in Abhängigkeit der ermittelten Veränderung der Motorkonstanten k ermittelt. Der Korrekturwert ist beispielsweise ein Korrekturwert ΔI (siehe Fig. 3, 4 oder 8) für den Ansteuerstrom I (siehe Fig. 2 oder 7), mit dem der Aktuator 200 beaufschlagt wird.

In einem fünften Schritt S5 wird der Aktuator 200 mit einer zweiten elektrischen Ansteuerleistung PS in Abhängigkeit der ersten elektrischen Ansteuerleistung PS und des ermittelten Korrekturwerts angesteuert. Die zweite elektrische Ansteuerleistung PS ist beispielsweise eine Summe aus der ersten elektrischen Ansteuerleistung PS und dem Korrekturwert.

Auf diese Weise wird die Veränderung der Motorkonstanten k aufgrund einer Erwärmung des Aktuators 200 kompensiert, so dass die durch den Aktuator 200 bereitgestellte Kraft A der geforderten Sollkraft FS entspricht. Beispielsweise ist die bereitgestellte Kraft A bei einer konstanten Sollkraft FS ebenfalls konstant, obwohl sich die Motorkonstante k langsam verändert, ohne dass eine explizite Kraftregelung für den Aktuator 200 notwendig ist. Der Ermittlung des mathematischen Modells kommt hierbei besondere Bedeutung zu, da dieses die Genauigkeit der Kompensation im Wesentlichen festlegt.

Fig. 2 zeigt schematisch ein Ausführungsbeispiel eines magnetischen Aktuators 200, der beispielsweise gemäß dem Verfahren aus Fig. 1 betrieben werden kann. Der magnetische Aktuator 200 umfasst einen Permanentmagneten 210 der von einer Leiteranordnung 220, die hier eine Spule bildet, eingefasst ist. Der Permanentmagnet 210 des Aktuators 200 ist auf einer Seite mit dem zu aktuierenden Element 230 mechanisch verbunden. Damit ist sichergestellt, dass die Kraft A, die der Aktuator 200 bereitstellt, auf das Element 230 übertragen wird. Auf der anderen Seite ist der Permanentmagnet 210 über ein Koppelelement 240 und einem starren Kraftrahmen 250 befestigt. Das Koppelelement 240 überträgt die der Kraft A entgegengesetzt wirkende Kraft auf den Kraftrahmen 250, der einen mechanischen Fixpunkt für den Aktuator 200 bildet. Das Koppelelement 240 ist beispielsweise als eine Feder ausgebildet, die eine Ruhelage des Permanentmagneten 210 in Bezug auf den Kraftrahmen 250 festlegt und eine Relativbewegung zwischen dem Permanentmagneten 210 und dem Kraftrahmen 250 zulässt. Die Auslenkung ist beispielsweise proportional zu der Kraft A, weshalb die beiden Begriffe gegeneinander austauschbar verwendet werden können.

Die Leiteranordnung 220 ist mit einer Spannungs- oder Stromquelle V verbunden, welche eine elektrische Ansteuerleistung PS (siehe Fig. 8, 9, 10A oder 10B) bereitstellt. Die elektrische Ansteuerleistung PS kann beispielsweise gemäß dem Ohm'schen Gesetz als das Produkt aus der Ansteuerspannung VS und dem Ansteuerstrom IS berechnet werden. Um eine höhere Genauigkeit zu erreichen, kann eine Phasenlage von Strom und Spannung berücksichtigt werden. Die Leiteranordnung 220 ist vorzugsweise relativ zu dem Kraftrahmen 250 fixiert.

Wenn die Spannungsquelle V die Leiteranordnung 220 mit einem Ansteuerstrom IS bestromt, baut sich insbesondere innerhalb der Spule, also im Bereich des Permanentmagneten 210, ein induziertes magnetisches Feld auf. Dieses tritt in Wechselwirkung mit dem Magnetfeld des Permanentmagneten 210, wodurch sich eine mechanische Kraftwirkung ergibt. Weiterhin führt die Wechselwirkung zu einer Erwärmung des Permanentmagneten 210. Die Erwärmung hat den Effekt, dass die Magnetisierung des Permanentmagneten 210 schwächer wird, was sich auf die Größe der Kraftwirkung auswirkt. Dies ist nachfolgend anhand der Fig. 3 genauer beschrieben.

Fig. 3 zeigt ein beispielhaftes Diagramm einer Motorkonstante k für einen elektrischen Aktuator 200, beispielsweise einer der in den Fig. 2, 7 - 8, 10A oder 10B gezeigten, bei zwei unterschiedlichen Temperaturen T1 und T2.

Das Diagramm zeigt eine Stromachse I und eine Kraftachse F. Die Linien T1 und T2 entsprechend dem funktionalen Zusammenhang der bereitgestellten Kraft des magnetischen Aktuators 200 in Abhängigkeit des Stroms I, mit dem der Aktuator 200 angesteuert wird. Anstelle des Stroms I könnte auch die Spannung oder allgemein die elektrische Leistung stehen. Die Motorkonstante k des Aktuators 200 ist durch die Steigung der jeweiligen Linie T1, T2 gegeben. Die Linie T1 entspricht hierbei beispielsweise einer Temperatur von 25°C, die Linie T2 entspricht beispielswiese einer Temperatur von 45°C. Aus dieser Darstellung ist sofort ersichtlich, dass zur Erzielung der gleichen Kraft, beispielsweise der Sollkraft FS, bei unterschiedlichen Temperaturen auch unterschiedliche Ströme benötigt werden. So ist beispielsweise von einem ersten Stromwert I0, der bei 25°C zum Erzielen der Sollkraft FS ausreicht (Linie T1), ein um einen Differenzbetrag $\Delta$I erhöhter Stromwert Iinf notwendig, um bei der Temperatur von 45°C die gleiche Sollkraft FS zu erzielen (Linie T2). Da sich die Temperatur des Aktuators 200 hauptsächlich aufgrund der Ansteuerung mit der elektrischen Ansteuerleistung PS erhöht (und entsprechend sinkt, wenn die elektrische Ansteuerleistung PS zurückgeht), kann das dynamische Verhalten des Aktuators 200 anhand eines mathematischen Modells auf Basis der bekannten elektrischen Ansteuerleistung PS simuliert werden.

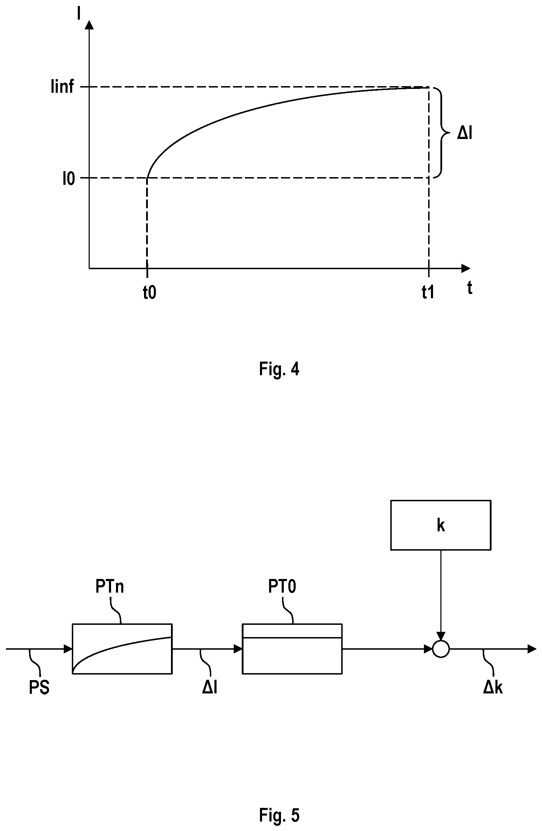

Die Fig. 4 zeigt ein beispielhaftes Diagramm einer Veränderung einer Ansteuerleistung zum Bereitstellen einer konstanten Kraft, beispielsweise für einen der in den Fig. 2, 7 - 9, 10A oder 10B magnetischen Aktuatoren 200. Das Diagramm hat eine horizontale Zeitachse t und eine vertikale Stromachse I, wobei der Strom I hierbei stellvertretend für die elektrische Leistung betrachtet wird. Zu einem ersten Zeitpunkt t0 wird der Aktuator 200 mit einem ersten Strom I0 bestromt. Wie vorstehend bereits erläutert führt dies zu einer Erwärmung des Permanentmagneten 210 (siehe Fig. 2) und in der Folge zu einer reduzierten Motorkonstanten k (siehe Fig. 3). Um dennoch die gleiche Kraft bereitzustellen, muss der Aktuator 200 mit einem entsprechend der Temperatur des Permanentmagneten 210 stetig steigenden Ansteuerstrom IS betrieben werden. Zu einem Zeitpunkt t1 ist beispielsweise ein thermisches Gleichgewicht in dem Permanentmagneten 210 erreicht, weshalb die Motorkonstante k sich nicht weiter verändert und der Ansteuerstrom IS stabil bei einem Wert Iinf = I0 + $\Delta$I bleibt. Wie lange es dauert, bis das thermische Gleichgewicht erreicht ist, hängt von verschiedenen Faktoren, insbesondere einer Wärmekapazität und einer Wärmeleitfähigkeit des Aktuators 200 ab. Das zeitdynamische Verhalten des Aktuators 200 lässt sich beispielsweise mittels einer P-Regelstrecke darstellen, wie nachfolgend anhand der Fig. 5 erläutert ist.

Fig. 5 zeigt ein schematisches Blockschaltbild eines mathematischen Modells eines magnetischen Aktuators 200, beispielsweise des in einer der Fig. 2, 7 - 9, 10A oder 10B dargestellten Aktuators 200. Das mathematische Modell ist hier in Form einer P-Regelstrecke dargestellt, die ein P-Glied n-ter Ordnung PTn und ein Proportionalglied PT0 in Reihenschaltung aufweist. Unter Berücksichtigung einer nominellen Motorkonstante k, beispielsweise der Motorkonstante k des modellierten Aktuators 200 bei Normalbedingungen, ergibt sich als Ausgangswert der P-Regelstrecke die Veränderung $\Delta$k der Motorkonstanten k. Die Veränderung $\Delta$k der Motorkonstanten k lässt sich als Funktion des Ansteuerstroms IS und der Zeit t beispielsweise gemäß Gleichung (3) schreiben.

$$\Delta k(t) = k \cdot \Delta I(t) / (IS + \Delta I(t)) \qquad \text{Gleichung (3).}$$

Hierbei ist $\Delta$I(t) der zeitlich veränderliche Anteil des Ansteuerstroms IS, wie beispielsweise in den Diagrammen der Fig. 3 oder 4 dargestellt.

Eingangsgröße für die P-Regelstrecke ist die elektrische Ansteuerleistung PS. Das PTn-Glied, das beispielsweise ein PT1-Glied ist, gibt als Ausgangswert den Korrekturwert $\Delta$I für den Strom aus. Das PTn-Glied ist beispielsweise durch wenigstens eine Zeitkonstante und einen Verstärkungsfaktor charakterisiert. Das PT0-Glied beschreibt beispielsweise auf Basis des Korrekturwerts $\Delta$I und der nominellen Motorkonstanten k die Veränderung $\Delta$k der Motorkonstanten k.

Fig. 6 zeigt ein weiteres schematisches Blockschaltbild eines mathematischen Modells eines magnetischen Aktuators 200, beispielsweise des in einer der Fig. 2, 7 - 9, 10A oder 10B dargestellten Aktuators 200. Das mathematische Modell ist hier, ähnlich zu Fig. 5, in Form einer P-Regelstrecke dargestellt. Im Unterschied zur Fig. 5 sind hier zwei P-Glieder n-ter Ordnung PTn mit einem Proportionalglied PT0 in Reihenschaltung angeordnet. Die Gesamtübertragungsfunktion der dargestellten P-Regelstrecke entspricht derjenigen der in Fig. 5 dargestellten. Um sicherzustellen, dass das mathematische Modell nicht von der Realität abdriftet, was beispielsweise durch Modellungenauigkeiten oder kleine Diskrepanzen zwischen der dem mathematischen Modell als Eingangsgröße bereitgestellten elektrischen Ansteuerleistung PS und der tatsächlichen Ansteuerleistung vorkommen könnte, wird hier eine Aktuator-Temperatur T, vorzugsweise die Spulentemperatur, als physikalische Messgröße des magnetischen Aktuators 200 dem mathematischen Modell zugeführt. Auf diese Weise ist sichergestellt, dass die dynamische Entwicklung des mathematischen Modells an das tatsächliche Verhalten des Aktuators 200 gekoppelt bleibt.

Das erste PTn-Glied beschreibt beispielsweise die Übertragungsfunktion zwischen der elektrischen Ansteuerleistung PS und einer Spulentemperatur T des magnetischen Aktuators 200. Wenn die dem mathematischen Modell zugeführte elektrische Ansteuerleistung PS fehlerhaft ist, ergibt sich in der Folge eine fehlerhafte Spulentemperatur T. Indem die Spulentemperatur T vorliegend als Messwert dem Modell zugeführt wird, können Messfehler, insbesondere der elektrischen Ansteuerleistung PS, korrigiert werden. Die Spulentemperatur T wird vorzugsweise auf Basis einer Spulenspannung und eines Spulenstroms erfasst.

Fig. 7 zeigt ein schematisches Blockschaltbild einer Anordnung zum Ermitteln eines mathematischen Modells eines magnetischen Aktuators 200. Der magnetische Aktuator 200 wird hierbei über einen von einer Regeleinheit 300 geregelten Ansteuerstromkreis betrieben. Dem Aktuator 200 ist eine Sensoreinheit 310 zugeordnet, welche eine bereitgestellte Kraft oder eine bewirkte Auslenkung des Aktuators 200 erfasst und an die Regeleinheit 300 ausgibt. Weiterhin sind eine Strommesseinheit zum Messen des Ansteuerstroms IS und eine Spannungsmesseinheit zum Messen einer Ansteuerspannung VS in dem Stromkreis angeordnet. Die Regeleinheit 300 regelt beispielsweise auf die Kraft oder Auslenkung des Aktuators 200. Zum Beispiel ist die Ansteuerspannung VS konstant, so dass durch Veränderung des Ansteuerstroms IS die Veränderung der Motorkonstanten k (siehe Fig. 3) kompensiert wird. Daher steuert die Regeleinheit 300 die Spannungsquelle V mittels eines zeitlich veränderlichen Stroms I(t).

Eine Ermittlungseinheit 320 empfängt von der Regeleinheit 300 beispielsweise alle Mess-, Sensor,- und Steuersignale. So lässt sich durch Aufzeichnen des zeitlich veränderlichen Steuersignals I(t) das PT0-Glied und das PTn-Glied aus Fig. 5 identifizieren, das heißt, es lassen sich die Parameterwerte des PT0-Glieds und des PTn-Glieds ermitteln. Die Ermittlungseinheit 320 kann verschiedene automatische Algorithmen anwenden, um das mathematische Modell zu identifizieren. Hierbei kann beispielsweise eine Mehrzahl an unterschiedlichen Modellen vorgegeben sein, aus denen die Ermittlungseinheit 320 das beste Modell auswählt. Das "beste Modell" ist hierbei vorzugsweise dasjenige Modell, welches die kleinste Abweichung gemäß eines bestimmten Gütefaktors aufweist. Die Ermittlungseinheit 320 kann insbesondere auch ein neuronales Netzwerk umfassen, welches das Ermitteln des mathematischen Modells zumindest teilweise durchführt oder unterstützt. Beispielsweise kann ein solches neuronales Netzwerk dazu verwendet werden, um eine Vorauswahl aus der Mehrzahl möglicher mathematischer Modelle zu treffen.

Fig. 8 zeigt ein schematisches Blockschaltbild einer Ansteuereinrichtung 400 zum Ansteuern eines magnetischen Aktuators 200, beispielsweise des in den Fig. 2, 7, 9, 10A oder 10B gezeigten magnetischen Aktuators 200. Die Ansteuereinrichtung 400 ist insbesondere zum Durchführen des anhand der Fig. 1 beschriebenen Verfahrens eingerichtet. Der Ansteuereinrichtung 400 wird eine vorbestimmte Sollkraft FS von außen, beispielsweise von einem Steuerrechner (nicht gezeigt), zugeführt. Anstelle der vorbestimmten Sollkraft FS kann auch eine vorbestimmten Sollposition des Aktuators 200 betrachtet werden. Die Ansteuereinrichtung 400 ist dazu eingerichtet, den Aktuator 200 mit einer elektrischen Ansteuerleistung PS anzusteuern, so dass der Aktuator 200 die vorbestimmte Sollkraft FS bereitstellt und somit die vorbestimmte Sollposition anfährt.

Hierzu umfasst die Ansteuereinrichtung 400 eine Ansteuerungseinheit 420, die insbesondere eine geregelte Spannungs- oder Stromquelle V (siehe Fig. 2 oder 7) umfasst, die die elektrische Ansteuerleistung PS bereitstellen kann. Weiterhin umfasst die Ansteuereinrichtung 400 eine Auswerteeinheit 430, welche dazu eingerichtet ist, in Abhängigkeit der aktuellen Ansteuerleistung PS ein mathematisches Modell des Aktuators 200, das von einer Modelliereinheit 410 bereitgestellt wird, auszuwerten. Beispielsweise ist das mathematische Modell in Form einer P-Regelstrecke (siehe Fig. 5 oder 6) gegeben. Die Auswerteeinheit 430 führt die Ansteuerleistung PS als Eingangssignal zu und erhält als Ausgangssignal einen Wert für die Veränderung $\Delta k$ der Motorkonstante k des Aktuators 200. Der Wert $\Delta k$ wird einer Korrektureinheit 440 zugeführt, die auf Basis des Werts $\Delta k$ einen Korrekturwert $\Delta I$ für die Ansteuerleistung PS, der in diesem Beispiel als ein Korrekturwert $\Delta I$ für den Ansteuerstrom IS (siehe Fig. 2 oder 7) dargestellt ist.

Die Ansteuerungseinheit 420 ändert die Ansteuerleistung PS um den Korrekturwert $\Delta I$, beispielsweise wird der Ansteuerstrom IS um den Korrekturwert $\Delta I$ erhöht oder erniedrigt. Das mathematische Modell wird fortlaufend auf Basis der Ansteuerleistung PS ausgewertet. Da alle früheren Ansteuerleistungen PS in dem mathematischen Modell ebenfalls zugeführt wurden, sind diese in dem aktuellen Zustand des mathematischen Modells berücksichtigt. Daher kann das mathematische Modell auch zeitlich stark verzögerte Vorgänge in Abhängigkeit der Ansteuerleistung PS korrekt darstellen. In vielen Anwendungsfällen ändert sich die Sollkraft FS oder die korrespondierende Sollposition mit einer hohen Frequenz von 1 - 100 kHz, wobei sich die Motorkonstante k um Größenordnungen langsamer verändert, was an der vergleichsweise langsamen Änderung der Aktuator-Temperatur in Reaktion auf eine geänderte Ansteuerleistung PS liegt. Durch die Korrektur der elektrischen Ansteuerleistung PS auf Basis des mathematischen Modells ist eine Kompensation der Veränderung $\Delta k$ der Motorkonstante k des Aktuators 200 bereits vor einem Eingreifen einer geschlossenen Regelschleife, und daher einerseits schneller und andererseits mit einem geringeren Aufwand, möglich, wodurch eine Präzision der Aktuierung durch den Aktuator 200 verbessert wird.

Fig. 9 zeigt schematisch ein Ausführungsbeispiel eines optischen Systems 500. Bei dem optischen System 500 handelt es sich beispielsweise um einen Beleuchtungsstrahlengang, zum Beispiel in einem Mikroskop. Das optische System 500 umfasst eine Lichtquelle LS, deren Licht von einer ersten Linse 128 kollimiert wird. Das kollimierte Licht fällt auf ein erstes optisches Element 510, das als ein Planspiegel ausgeführt ist und mittels eines magnetischen Aktuators 200 um eine Achse verschwenkbar gelagert ist, um eine Richtung des kollimierten Lichts zu steuern. Das Licht wird auf ein zweites optisches Element 510 reflektiert, das hier als ein parabolisch gekrümmter Spiegel ausgebildet ist, der das Licht auf einen Punkt auf einem Objekt 124 fokussiert.

Bei dem magnetischen Aktuator 200 handelt es sich beispielsweise um den in einer der Fig. 2, 7 oder 8 dargestellten magnetischen Aktuator 200. Der magnetische Aktuator 200 wird hierbei insbesondere von einer Ansteuereinrichtung 400, wie anhand der Fig. 8 beschrieben, und gemäß dem anhand der Fig. 1 beschriebenen Verfahren gesteuert. Wie anhand der Fig. 8 beschrieben, wird der Ansteuereinrichtung 400 eine vorbestimmte Sollkraft FS, die hier einem vorbestimmten Winkel des Planspiegels 510 in Bezug auf das einfallende Licht und damit einer bestimmten Beleuchtungsposition auf dem Objekt 124 entspricht, von außen zugeführt. Die Ansteuereinrichtung 400 steuert daraufhin den Aktuator 200 mit der elektrischen Ansteuerleistung PS an, so dass der Planspiegel 510 auf den vorbestimmten Winkel eingestellt wird. Um eine langsame Veränderung des Winkels und damit einer Verschiebung der Beleuchtungsposition aufgrund der Erwärmung des Aktuators 200 entgegenzuwirken, wird die elektrische Ansteuerleistung PS fortlaufend wie anhand der Fig. 8 beschrieben durch die Ansteuereinrichtung 400 auf Basis des mathematischen Modells kompensiert. Die Beleuchtung des Objekts 124 ist damit sehr präzise möglich. Es versteht sich, dass die Ansteuereinrichtung 400 eine weitergehende Regelung, beispielsweise mittels eines geschlossenen Regelkreises, nicht ausschließt, sondern ergänzend hierzu eingesetzt werden kann.

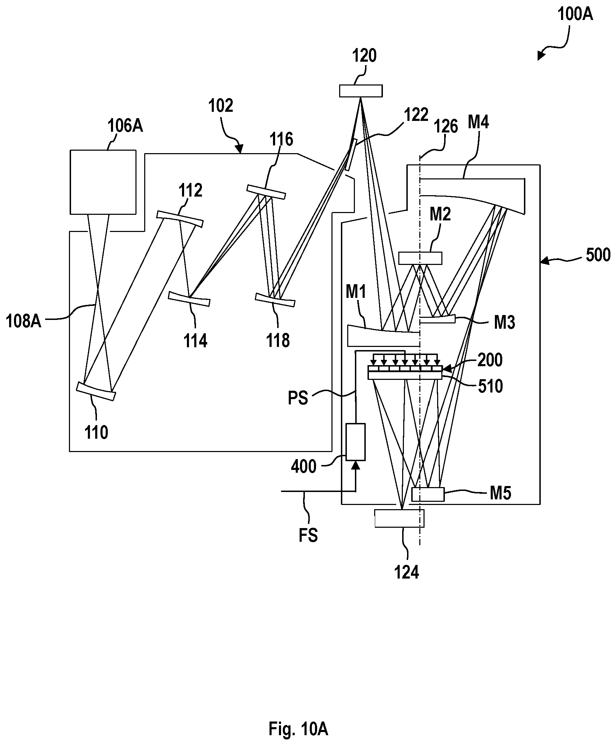

Fig. 10A zeigt eine schematische Ansicht einer EUV-Lithographieanlage 100A, welche ein Strahlformungs- und Beleuchtungssystem 102 und ein optisches System 500, das als Projektionssystem ausgebildet ist, umfasst. Dabei steht EUV für "extremes Ultraviolett" (Engl.: extreme ultraviolet, EUV) und bezeichnet eine Wellenlänge des Arbeitslichts zwischen 0,1 nm und 30 nm. Das Strahlformungs- und Beleuchtungssystem 102 und das Projektionssystem 500 sind jeweils in einem nicht gezeigten Vakuum-Gehäuse vorgesehen, wobei jedes Vakuum-Gehäuse mit Hilfe einer nicht dargestellten Evakuierungsvorrichtung evakuiert wird. Die Vakuum-Gehäuse sind von einem nicht dargestellten Maschinenraum umgeben, in welchem Antriebsvorrichtungen zum mechanischen Verfahren beziehungsweise Einstellen von optischen Elementen vorgesehen sind. Ferner können auch elektrische Steuerungen und dergleichen in diesem Maschinenraum vorgesehen sein.

Die EUV-Lithographieanlage 100A weist eine EUV-Lichtquelle 106A auf. Als EUV-Lichtquelle 106A kann beispielsweise eine Plasmaquelle (oder ein Synchrotron) vorgesehen sein, welche Strahlung 109A im EUV-Bereich (extrem ultravioletter Bereich), also beispielsweise im Wellenlängenbereich von 5 nm bis 20 nm, aussendet. Im Strahlformungs- und Beleuchtungssystem 102 wird die EUV-Strahlung 109A gebündelt und die gewünschte Betriebswellenlänge aus der EUV-Strahlung 109A herausgefiltert. Die von der EUV-Lichtquelle 106A erzeugte EUV-Strahlung 109A weist eine relativ niedrige Transmissivität durch Luft auf, weshalb die Strahlführungsräume im Strahlformungs- und Beleuchtungssystem 102 und im Projektionssystem 500 evakuiert sind.

Das in Fig. 10A dargestellte Strahlformungs- und Beleuchtungssystem 102 weist fünf Spiegel 110, 112, 114, 116, 118 auf. Nach dem Durchgang durch das Strahlformungs- und Beleuchtungssystem 102 wird die EUV-Strahlung 109A auf eine Photomaske (Engl.: reticle) 120 geleitet. Die Photomaske 120 ist ebenfalls als reflektives optisches Element ausgebildet und kann außerhalb der Systeme 102, 500 angeordnet sein. Weiter kann die EUV-Strahlung 109A mittels eines Spiegels 122 auf die Photomaske 120 gelenkt werden. Die Photomaske 120 weist eine Struktur auf, welche mittels des Projektionssystems 500 verkleinert auf ein Objekt 124, insbesondere einen Wafer oder dergleichen, abgebildet wird.

Das Projektionssystem 500 (auch als Projektionsobjektiv bezeichnet) weist fünf Spiegel M1 bis M5 und ein mittels einer Mehrzahl an magnetischen Aktuatoren 200 aktuierbares optisches Element 510 zur Abbildung der Photomaske 120 auf den Wafer 124 auf. Dabei können einzelne Spiegel M1 bis M5 und das optische Element 510 des Projektionssystems 500 symmetrisch zu einer optischen Achse 126 des Projektionssystems 500 angeordnet sein. Es sollte beachtet werden, dass die Anzahl der Spiegel M1 bis M5 der EUV-Lithographieanlage 100A nicht auf die dargestellte Anzahl beschränkt ist. Es können auch mehr oder weniger Spiegel M1 bis M5 vorgesehen sein. Des Weiteren sind die Spiegel M1 bis M5 in der Regel an ihrer Vorderseite zur Strahlformung gekrümmt. Weiterhin können einzelne oder alle der Spiegel M1 bis M5 entsprechend dem optischen Element 510 mittels eines oder mehrerer Aktuatoren 200 aktuierbar ausgestaltet sein.

Die Aktuatoren 200 entsprechen beispielsweise den in den Fig. 2 oder 7 - 9 gezeigten. Das optische Element 510 ist vorliegend als ein Spiegel, dessen Vorderseite durch die Aktuatoren 200 deformierbar ist, ausgestaltet. Mit dem optischen Element 510 lassen sich beispielsweise optische Aberrationen ausgleichen, so dass eine Auflösung der EUV-Lithographieanlage 100A erhöht ist. Jeder der Aktuatoren 200 wird über eine diesem zugeordnete Ansteuereinrichtung 400, wie anhand der Fig. 8 erläutert, angesteuert. In der Fig. 10A ist aus Gründen der Übersicht nur eine Ansteuereinrichtung 400 dargestellt. Wie vorstehend beschrieben, empfängt die jeweilige Ansteuereinrichtung 400 eine vorbestimmte Sollkraft FS, die der zugeordnete Aktuator 200 aufbringen oder bereitstellen soll, und steuert daraufhin den zugeordneten Aktuator 200 mit der elektrischen Ansteuerleistung PS an, die wie vorstehend beschrieben laufend korrigiert oder angepasst wird. Die vorbestimmte Sollkraft FS kann dabei insbesondere einen vorbestimmtes zeitlichen Kraftverlauf umfassen.

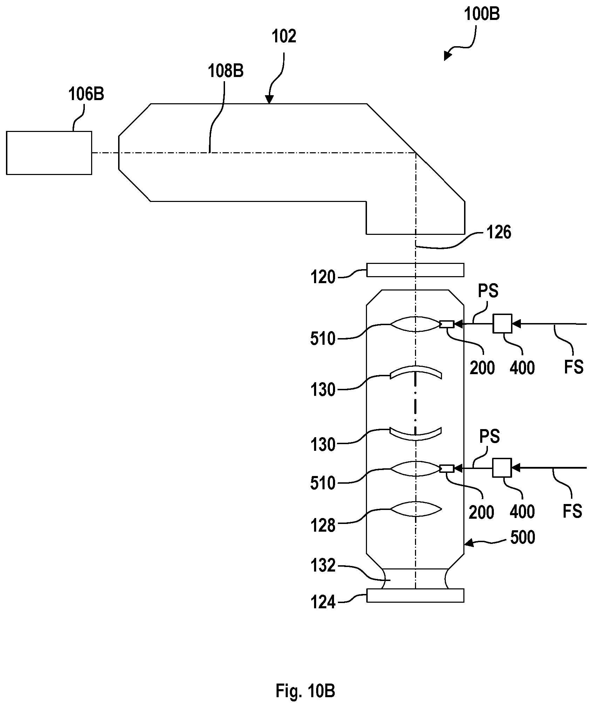

Fig. 10B zeigt eine schematische Ansicht einer DUV-Lithographieanlage 100B, welche ein Strahlformungs- und Beleuchtungssystem 102 und ein als Projektionssystem ausgebildetes optisches System 500 umfasst. Dabei steht DUV für "tiefes Ultraviolett" (Engl.: deep ultraviolet, DUV) und bezeichnet eine Wellenlänge des Arbeitslichts zwischen 30 nm und 250 nm. Das Strahlformungs- und Beleuchtungssystem 102 und das Projektionssystem 500 können - wie bereits mit Bezug zu Fig. 10A beschrieben - in einem Vakuumgehäuse angeordnet und/oder von einem Maschinenraum mit entsprechenden Antriebsvorrichtungen umgeben sein.

Die DUV-Lithographieanlage 100B weist eine DUV-Lichtquelle 106B auf. Als DUV-Lichtquelle 106B kann beispielsweise ein ArF-Excimerlaser vorgesehen sein, welcher Strahlung 109B im DUV-Bereich bei beispielsweise 193 nm emittiert.

Das in Fig. 10B dargestellte Strahlformungs- und Beleuchtungssystem 102 leitet die DUV-Strahlung 109B auf eine Photomaske 120. Die Photomaske 120 ist als transmissives optisches Element ausgebildet und kann außerhalb der Systeme 102, 500 angeordnet sein. Die Photomaske 120 weist eine Struktur auf, welche mittels des Projektionssystems 500 verkleinert auf ein Objekt 124, insbesondere einen Wafer oder dergleichen, abgebildet wird.

Das Projektionssystem 500 weist mehrere Linsen 128, Spiegel 130 und/oder mittels magnetischer Aktuatoren 200 aktuierbare optische Elemente 510 zur Abbildung der Photomaske 120 auf den Wafer 124 auf. Dabei können einzelne Linsen 128, Spiegel 130 und/oder optische Elemente 510 des Projektionssystems 500 symmetrisch zu einer optischen Achse 126 des Projektionssystems 500 angeordnet sein. Es sollte beachtet werden, dass die Anzahl der Linsen 128 und Spiegel 130 der DUV-Lithographieanlage 100B nicht auf die dargestellte Anzahl beschränkt ist. Es können auch mehr oder weniger Linsen 128 und/oder Spiegel 130 vorgesehen sein. Des Weiteren sind die Spiegel 130 in der Regel an ihrer Vorderseite zur Strahlformung gekrümmt. Weiterhin können einzelne oder alle der Linsen 128 und/oder Spiegel 130 entsprechend dem optischen Element 510 mittels eines oder mehrerer Aktuatoren 200 aktuierbar ausgestaltet sein.

Die Aktuatoren 200 entsprechen beispielsweise den in den Fig. 2 oder 7 - 9 gezeigten. Die optischen Element 510 sind vorliegend als verschiebbare Linsen ausgestaltet. Mit dem optischen Element 510 lassen sich beispielsweise optische Aberrationen ausgleichen, so dass eine Auflösung der DUV-Lithographieanlage 100B erhöht ist. Jeder der Aktuatoren 200 wird über eine diesem zugeordnete Ansteuereinrichtung 400, wie anhand der Fig. 8 erläutert, angesteuert. Wie vorstehend beschrieben, empfängt die jeweilige Ansteuereinrichtung 400 eine vorbestimmte Sollkraft FS, die hier einer vorbestimmten Position der jeweiligen Linse 510 entspricht, die der zugeordnete Aktuator 200 aufbringen oder bereitstellen soll, und steuert daraufhin den zugeordneten Aktuator 200 mit der elektrischen Ansteuerleistung PS an, die wie vorstehend beschrieben laufend korrigiert oder angepasst wird.

Ein Luftspalt zwischen der letzten Linse 128 und dem Wafer 124 kann durch ein flüssiges Medium 132 ersetzt sein, welches einen Brechungsindex > 1 aufweist. Das flüssige Medium 132 kann beispielsweise hochreines Wasser sein. Ein solcher Aufbau wird auch als Immersionslithographie bezeichnet und weist eine erhöhte photolithographische Auflösung auf. Das Medium 132 kann auch als Immersionsflüssigkeit bezeichnet werden.

Obwohl die vorliegende Erfindung anhand von Ausführungsbeispielen beschrieben wurde, ist sie vielfältig modifizierbar.

BEZUGSZEICHENLISTE

| | |
|---|---|
| 100A | EUV-Lithographieanlage |
| 100B | DUV-Lithographieanlage |
| 102 | Strahlformungs- und Beleuchtungssystem |
| 106A | EUV-Lichtquelle |
| 106B | DUV-Lichtquelle |
| 109A | EUV-Strahlung |
| 109B | DUV-Strahlung |
| 110 | Spiegel |
| 112 | Spiegel |
| 114 | Spiegel |
| 116 | Spiegel |
| 118 | Spiegel |
| 120 | Photomaske |
| 122 | Spiegel |
| 124 | Objekt |
| 126 | optische Achse |
| 128 | Linse |
| 130 | Spiegel |
| 132 | Medium |
| 200 | Aktuator |
| 210 | Permanentmagnet |
| 220 | Leiteranordnung |
| 230 | aktuiertes Element |
| 240 | Koppelelement |
| 250 | Kraftrahmen |

EP 4 133 589 B1

300 Regelungseinheit
310 Erfassungseinheit
320 Ermittlungseinheit
400 Ansteuereinrichtung
410 Modelliereinheit
420 Ansteuerungseinheit
430 Auswerteeinheit
440 Korrektureinheit
500 optisches System
510 optisches Element

A Kraft
FS Sollkraft
I Strom
I0 Stromwert
Iinf Stromwert
IS Ansteuerstrom
k Motorkonstante
LS Lichtquelle
M1 Spiegel
M2 Spiegel
M3 Spiegel
M4 Spiegel
M5 Spiegel
PS elektrische Ansteuerleistung
PT0 Proportionalglied
PTn P-Glied n-ter Ordnung
S1 Verfahrensschritt
S2 Verfahrensschritt
S3 Verfahrensschritt
S4 Verfahrensschritt
S5 Verfahrensschritt
t Zeit
t0 Zeitpunkt
t1 Zeitpunkt
T Temperatur
T1 Linie
T2 Linie
V Spannungs-/Stromquelle
VS Ansteuerspannung

ΔI Korrekturwert
Δk Veränderung

**Patentansprüche**

1. Verfahren zum Betreiben eines magnetischen Aktuators (200), insbesondere zum Aktuieren eines optischen Elements (510) in einem optischen System (500), welcher zum Bereitstellen einer mechanischen Kraft (A) in Abhängigkeit einer elektrischen Ansteuerleistung (PS) eingerichtet ist, wobei das Verfahren umfasst:

A) Ermitteln (S1) eines mathematischen Modells des Aktuators (200), welches eine Veränderung einer Motorkonstante (k) des Aktuators (200) in Abhängigkeit der zugeführten elektrischen Ansteuerleistung (PS) beschreibt, das Verfahren ist **gekennzeichnet durch** das

B) Ansteuern (S2) des Aktuators (200) mit einer ersten elektrischen Ansteuerleistung (PS) in Abhängigkeit einer vorbestimmten Sollkraft (FS),

C) Ermitteln (S3) der Veränderung der Motorkonstante (k) des Aktuators (200) aufgrund des Ansteuerns des Aktuators (200) mit der ersten elektrischen Ansteuerleistung (PS) mittels des mathematischen Modells,

D) Ermitteln (S4) eines Korrekturwerts für die erste elektrische Ansteuerleistung (PS) in Abhängigkeit der

14

ermittelten Veränderung der Motorkonstante (k), und

E) Ansteuern des Aktuators (200) mit einer zweiten elektrischen Ansteuerleistung (PS) in Abhängigkeit der ersten elektrischen Ansteuerleistung (PS) und des ermittelten Korrekturwerts.

2. Verfahren gemäß Anspruch 1, wobei die jeweilige elektrische Ansteuerleistung (PS) proportional zu einem Eingangsstrom (I) an dem Aktuator (200) ist.

3. Verfahren gemäß Anspruch 1 oder 2, **dadurch gekennzeichnet, dass** der Schritt A) umfasst:

A1) Ansteuern des Aktuators (200) mit der ersten elektrischen Ansteuerleistung (PS) zum Bereitstellen der vorbestimmten Sollkraft (FS),
A2) Erfassen der durch den Aktuator (200) bereitgestellten Kraft (A),
A3) Regeln der ersten elektrischen Ansteuerleistung (PS) in Abhängigkeit der erfassten Kraft,
A4) Erfassen einer zeitlichen Veränderung der ersten elektrischen Ansteuerleistung (PS), und
A5) Bereitstellen eines den zeitlichen Verlauf beschreibenden Modells und/oder Ermitteln zumindest eines Parameterwerts des Modells in Abhängigkeit der erfassten zeitlichen Veränderung der ersten elektrischen Ansteuerleistung (PS).

4. Verfahren gemäß einem der Ansprüche 1 bis 3, **dadurch gekennzeichnet, dass** ein Erfassen der dem Aktuator (200) zugeführten elektrischen Ansteuerleistung (PS) vorgesehen ist, wobei diese bei dem Schritt C) zum Ermitteln der Veränderung der Motorkonstante (k) verwendet wird.

5. Verfahren gemäß einem der Ansprüche 1 bis 4, **dadurch gekennzeichnet, dass** ein Erfassen einer aktuellen Aktuator-Temperatur (T) vorgesehen ist, wobei die erfasste Aktuator-Temperatur (T) bei dem bei dem Schritt C) zum Ermitteln der Veränderung der Motorkonstante (k) als Rückkopplung von dem magnetischen Aktuator (200) verwendet wird.

6. Verfahren gemäß einem der Ansprüche 1 bis 5, **dadurch gekennzeichnet, dass** das mathematische Modell durch zumindest ein PT1-Glied und ein PT0-Glied abgebildet wird.

7. Verfahren gemäß einem der Ansprüche 1 bis 6, **dadurch gekennzeichnet, dass** das mathematische Modell auf Basis einer theoretischen Beschreibung des Aktuators (200) ausgewählt wird, wobei bei dem Schritt A) zumindest ein Parameterwert des Modells bestimmt wird.

8. Verfahren zum Betreiben eines optischen Systems (500), welches eine Anzahl von optischen Elementen (510) aufweist, wobei wenigstens eines der optischen Elemente (510) der Anzahl mittels eines gekoppelten magnetischen Aktuators (200) aktuierbar ist, wobei der Aktuator (200) zum Aktuieren des optischen Elements (200) mittels des Verfahrens gemäß einem der Ansprüche 1 bis 7 betrieben wird.

9. Computerprogrammprodukt, umfassend Befehle, die bei der Ausführung des Programms durch einen Computer diesen veranlassen, das Verfahren nach gemäß einem der Ansprüche 1 bis 8 durchzuführen.

10. Ansteuereinrichtung (400) zum Ansteuern eines magnetischen Aktuators (200) zum Bereitstellen einer mechanischen Kraft (A) in Abhängigkeit einer elektrischen Ansteuerleistung (PS), mit

einer Modelliereinheit (410) zum Bereitstellen eines mathematischen Modells des Aktuators (200), welches eine Veränderung einer Motorkonstante (k) des Aktuators (200) in Abhängigkeit der elektrischen Ansteuerleistung (PS) beschreibt,
einer Ansteuerungseinheit (420) zum Ansteuern des Aktuators (200) mit einer ersten elektrischen Ansteuerleistung (PS) in Abhängigkeit einer vorbestimmten Sollkraft (FS),
einer Auswerteeinheit (430) zum Ermitteln einer Veränderung der Motokonstante (k) des Aktuators (200) aufgrund des Ansteuerns des Aktuators (200) mit der ersten elektrischen Ansteuerleistung (PS) und in Abhängigkeit des von der Modelliereinheit (410) bereitgestellten mathematischen Modells, und
einer Korrektureinheit (440) zum Ermitteln eines Korrekturwerts für die erste elektrische Ansteuerleistung (PS) in Abhängigkeit der ermittelten Veränderung der Motorkonstante (k) des Aktuators (200), wobei
die Ansteuerungseinheit (420) dazu eingerichtet ist, den Aktuator (200) mit einer zweiten elektrischen Ansteuerleistung (PS) in Abhängigkeit der ersten elektrischen Ansteuerleistung (PS) und des ermittelten Korrekturwerts anzusteuern.

11. Ansteuereinrichtung gemäß Anspruch 10, **dadurch gekennzeichnet, dass** eine Erfassungseinheit zum Erfassen einer dem Aktuator (200) zugeführten elektrischen Ansteuerleistung (PS) vorgesehen ist, wobei die Auswerteeinheit (430) zum Ermitteln der Veränderung der Motokonstante (k) in Abhängigkeit der erfassten elektrischen Ansteuerleistung (PS) eingerichtet ist.

12. Mechanisches System mit zumindest einem magnetischen Aktuator (200) zum Aktuieren eines Stellelements, wobei der Aktuator (200) zum Bereitstellen einer mechanischen Kraft (A) in Abhängigkeit einer elektrischen Ansteuerleistung (PS) eingerichtet ist, **dadurch gekennzeichnet, dass** das mechanische System wenigstens eine Ansteuereinrichtung (400) zum Ansteuern des magnetischen Aktuators (200) gemäß Anspruch 10 oder 11 aufweist.

13. Optisches System (500) mit einer Anzahl an optischen Elementen (510), wobei wenigstens eines der optischen Elemente (510) der Anzahl mittels eines gekoppelten magnetischen Aktuators (200) aktuierbar ist, wobei der Aktuator (200) zum Bereitstellen einer mechanischen Kraft (A) in Abhängigkeit einer elektrischen Ansteuerleistung (PS) eingerichtet ist, **dadurch gekennzeichnet, dass** das optische System (500) wenigstens eine Ansteuereinrichtung (400) zum Ansteuern des magnetischen Aktuators (200) zum Aktuieren des optischen Elements (510) gemäß Anspruch 10 oder 11 aufweist.

14. Lithographieanlage (100A, 100B) mit einem optischen System (500) gemäß Anspruch 13.

**Claims**

1. Method for operating a magnetic actuator (200), in particular for actuating an optical element (510) in an optical system (500), said actuator being configured for providing a mechanical force (A) as a function of an electrical drive power (PS), wherein the method comprises:

   A) ascertaining (S1) a mathematical model of the actuator (200) which describes a change in a motor constant (k) of the actuator (200) as a function of the electrical drive power (PS) supplied, the method is **characterized by**
   B) driving (S2) the actuator (200) with a first electrical drive power (PS) as a function of a predetermined target force (FS),
   C) ascertaining (S3) the change in the motor constant (k) of the actuator (200) on account of driving the actuator (200) with the first electrical drive power (PS) by means of the mathematical model,
   D) ascertaining (S4) a correction value for the first electrical drive power (PS) as a function of the ascertained change in the motor constant (k), and
   E) driving the actuator (200) with a second electrical drive power (PS) as a function of the first electrical drive power (PS) and the ascertained correction value.

2. Method according to Claim 1, wherein the respective electrical drive power (PS) is proportional to an input current (I) at the actuator (200).

3. Method according to Claim 1 or 2, **characterized in that** step A) comprises:

   A1) driving the actuator (200) with the first electrical drive power (PS) for providing the predetermined target force (FS),
   A2) detecting the force (A) provided by the actuator (200),
   A3) controlling the first electrical drive power (PS) as a function of the detected force,
   A4) detecting a change in the first electrical drive power (PS) over time, and
   A5) providing a model describing the temporal profile and/or ascertaining at least one parameter value of the model as a function of the detected change in the first electrical drive power (PS) over time.

4. Method according to any of Claims 1 to 3, **characterized in that** detecting the electrical drive power (PS) supplied to the actuator (200) is provided, said power being used in step C) for ascertaining the change in the motor constant (k).

5. Method according to any of Claims 1 to 4, **characterized in that** detecting a present actuator temperature (T) is provided, the detected actuator temperature (T) being used as feedback from the magnetic actuator (200) in step C) for ascertaining the change in the motor constant (k).

6. Method according to any of Claims 1 to 5, **characterized in that** the mathematical model is represented by at least one PT1 element and a PT0 element.

7. Method according to any of Claims 1 to 6, **characterized in that** the mathematical model is selected on the basis of a theoretical description of the actuator (200), at least one parameter value of the model being determined in step A).

8. Method for operating an optical system (500) having a number of optical elements (510), wherein at least one of the optical elements (510) of the number is actuable by means of a coupled magnetic actuator (200), wherein the actuator (200) is operated for actuating the optical element (200) by means of the method according to any of Claims 1 to 7.

9. Computer program product comprising instructions which, when the program is executed by a computer, cause the latter to carry out the method according to any of Claims 1 to 8.

10. Drive device (400) for driving a magnetic actuator (200) for providing a mechanical force (A) as a function of an electrical drive power (PS), comprising

    a modeling unit (410) for providing a mathematical model of the actuator (200) which describes a change in a motor constant (k) of the actuator (200) as a function of the electrical drive power (PS),
    a driving unit (420) for driving the actuator (200) with a first electrical drive power (PS) as a function of a predetermined target force (FS),
    an evaluation unit (430) for ascertaining a change in the motor constant (k) of the actuator (200) on account of driving the actuator (200) with the first electrical drive power (PS) and as a function of the mathematical model provided by the modeling unit (410), and
    a correction unit (440) for ascertaining a correction value for the first electrical drive power (PS) as a function of the ascertained change in the motor constant (k) of the actuator (200), wherein
    the driving unit (420) is configured to drive the actuator (200) with a second electrical drive power (PS) as a function of the first electrical drive power (PS) and the ascertained correction value.

11. Drive device according to Claim 10, **characterized in that** a detection unit for detecting an electrical drive power (PS) supplied to the actuator (200) is provided, the evaluation unit (430) being configured for ascertaining the change in the motor constant (k) as a function of the detected electrical drive power (PS).

12. Mechanical system comprising at least one magnetic actuator (200) for actuating an actuating element, the actuator (200) being configured for providing a mechanical force (A) as a function of an electrical drive power (PS), **characterized in that** the mechanical system has at least one drive device (400) for driving the magnetic actuator (200) according to Claim 10 or 11.

13. Optical system (500) having a number of optical elements (510), wherein at least one of the optical elements (510) of the number is actuable by means of a coupled magnetic actuator (200), wherein the actuator (200) is configured for providing a mechanical force (A) as a function of an electrical drive power (PS), **characterized in that** the optical system (500) has at least one drive device (400) for driving the magnetic actuator (200) for actuating the optical element (510) according to Claim 10 or 11.

14. Lithography apparatus (100A, 100B) comprising an optical system (500) according to Claim 13.

**Revendications**

1. Procédé pour faire fonctionner un actionneur magnétique (200), en particulier pour actionner un élément optique (510) dans un système optique (500), qui est conçu pour fournir une force mécanique (A) en fonction d'une puissance électrique de commande (PS), le procédé comprenant :

    A) le fait (S1) de déterminer un modèle mathématique de l'actionneur (200) qui décrit une variation d'une constante de moteur (k) de l'actionneur (200) en fonction de la puissance électrique de commande (PS) fournie, le procédé étant **caractérisé par**
    B) le fait (S2) de commander l'actionneur (200) avec une première puissance électrique de commande (PS) en fonction d'une force de consigne (FS) prédéterminée,
    C) le fait (S3) de déterminer la modification de la constante de moteur (k) de l'actionneur (200) due à l'actionnement de l'actionneur (200) avec la première puissance électrique de commande (PS) au moyen du modèle mathématique,

D) le fait (S4) de déterminer une valeur de correction pour la première puissance électrique de commande (PS) en fonction de la variation déterminée de la constante de moteur (k), et

E) le fait de commander l'actionneur (200) avec une deuxième puissance électrique de commande (PS) en fonction de la première puissance électrique de commande (PS) et de la valeur de correction déterminée.

2. Procédé selon la revendication 1, dans lequel la puissance électrique de commande respective (PS) est proportionnelle à un courant d'entrée (I) au niveau de l'actionneur (200).

3. Procédé selon la revendication 1 ou la revendication 2, **caractérisé en ce que** l'étape A) comprend :

A1) le fait de commander l'actionneur (200) avec la première puissance électrique de commande (PS) pour fournir la force de consigne (FS) prédéterminée,

A2) le fait de détecter la force (A) fournie par l'actionneur (200),

A3) le fait de réguler la première puissance électrique de commande (PS) en fonction de la force détectée,

A4) le fait de détecter une variation dans le temps de la première puissance électrique de commande (PS), et

A5) le fait de fournir un modèle décrivant l'évolution dans le temps et/ou détermination d'au moins une valeur de paramètre du modèle en fonction de la variation dans le temps détectée de la première puissance électrique de commande (PS).

4. Procédé selon l'une des revendications 1 à 3, **caractérisé en ce qu'**il est prévu de détecter la puissance électrique de commande (PS) fournie à l'actionneur (200), celle-ci étant utilisée à l'étape C) pour déterminer la variation de la constante de moteur (k).

5. Procédé selon l'une des revendications 1 à 4, **caractérisé en ce qu'**il est prévu de détecter une température actuelle (T) de l'actionneur, la température détectée (T) de l'actionneur étant utilisée à l'étape C) pour déterminer la variation de la constante de moteur (k) en tant que rétroaction provenant de l'actionneur magnétique (200).

6. Procédé selon l'une des revendications 1 à 5, **caractérisé en ce que** le modèle mathématique est représenté par au moins un élément PT1 et un élément PT0.

7. Procédé selon l'une des revendications 1 à 6, **caractérisé en ce que** le modèle mathématique est sélectionné sur la base d'une description théorique de l'actionneur (200), au moins une valeur de paramètre du modèle étant déterminée à l'étape A).

8. Procédé pour faire fonctionner un système optique (500) qui comporte un certain nombre d'éléments optiques (510), au moins un des éléments optiques (510) de ce nombre étant apte à être actionné au moyen d'un actionneur magnétique (200) accouplé, l'actionneur (200) étant actionné de manière à actionner l'élément optique (200) au moyen du procédé selon l'une des revendications 1 à 7.

9. Produit de programme d'ordinateur comprenant des instructions qui, lors de l'exécution du programme par un ordinateur, amènent celui-ci à mettre en œuvre le procédé selon l'une des revendications 1 à 8.

10. Dispositif de commande (400) pour commander un actionneur magnétique (200) afin de fournir une force mécanique (A) en fonction d'une puissance de commande électrique (PS), comprenant

une unité de modélisation (410) pour fournir un modèle mathématique de l'actionneur (200) qui décrit une variation d'une constante de moteur (k) de l'actionneur (200) en fonction de la puissance de commande électrique (PS),

une unité de commande (420) pour commander l'actionneur (200) avec une première puissance électrique de commande (PS) en fonction d'une force de consigne (FS) prédéterminée,

une unité d'évaluation (430) pour déterminer une modification de la constante de moteur (k) de l'actionneur (200) due à l'actionnement de l'actionneur (200) avec la première puissance électrique de commande (PS) et en fonction du modèle mathématique fourni par l'unité de modélisation (410), et

une unité de correction (440) pour déterminer une valeur de correction pour la première puissance électrique de commande (PS) en fonction de la variation déterminée de la constante de moteur (k) de l'actionneur (200),

l'unité de commande (420) étant conçue pour commander l'actionneur (200) avec une deuxième puissance électrique de commande (PS) en fonction de la première puissance électrique de commande (PS) et de la valeur de correction déterminée.

11. Dispositif de commande selon la revendication 10, **caractérisé en ce qu'**une unité de détection est prévue pour détecter une puissance électrique de commande (PS) fournie à l'actionneur (200), l'unité d'évaluation (430) étant conçue de manière à déterminer la variation de la constante de moteur (k) en fonction de la puissance électrique de commande (PS) détectée.

12. Système mécanique comprenant au moins un actionneur magnétique (200) pour actionner un élément de réglage, l'actionneur (200) étant conçu pour fournir une force mécanique (A) en fonction d'une puissance électrique de commande (PS), **caractérisé en ce que** le système mécanique comprend au moins un dispositif de commande (400) pour commander l'actionneur magnétique (200) selon la revendication 10 ou la revendication 11.

13. Système optique (500) comprenant un certain nombre d'éléments optiques (510), au moins un des éléments optiques (510) de ce nombre étant apte à être actionné au moyen d'un actionneur magnétique (200) accouplé, l'actionneur (200) étant agencé pour fournir une force mécanique (A) en fonction d'une puissance électrique de commande (PS), **caractérisé en ce que** le système optique (500) comprend au moins un dispositif de commande (400) pour commander l'actionneur magnétique (200) afin d'actionner l'élément optique (510) selon la revendication 10 ou la revendication 11.

14. Installation de lithographie (100A, 100B) avec un système optique (500) selon la revendication 13.

Fig. 1

Fig. 2

Fig. 3

Fig. 4

Fig. 5

Fig. 6

Fig. 7

Fig. 8

Fig. 9

Fig. 10A

Fig. 10B

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2010284119 A1